(19) Europäisches Patentamt / European Patent Office / Office européen des brevets

(11) **EP 2 384 547 B1**

(12) **FASCICULE DE BREVET EUROPEEN**

(45) Date de publication et mention
de la délivrance du brevet:
**18.10.2017 Bulletin 2017/42**

(21) Numéro de dépôt: **10708259.6**

(22) Date de dépôt: **01.02.2010**

(51) Int Cl.:
*H03M 13/19* *(2006.01)*    *H03M 13/13* *(2006.01)*
*H03M 13/27* *(2006.01)*

(86) Numéro de dépôt international:
**PCT/FR2010/050158**

(87) Numéro de publication internationale:
**WO 2010/086572 (05.08.2010 Gazette 2010/31)**

(54) **PROCEDE ET DISPOSITIF DE CODAGE CORRECTEUR D'ERREURS FLEXIBLE ET PROGRAMME D'ORDINATEUR CORRESPONDANT**

KODIERUNGSVERFAHREN UND VORRICHTUNG ZUR FLEXIBLEN FEHLERKORREKTUR UND COMPUTERPROGRAMM DAFÜR

METHOD AND APPARATUS FOR FLEXIBLE ERROR CORRECTING CODING AND CORRESPONDING COMPUTER PROGRAM

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **30.01.2009 FR 0950628**

(43) Date de publication de la demande:
**09.11.2011 Bulletin 2011/45**

(73) Titulaire: **3G Licensing S.A.**
**2132 Luxembourg (LU)**

(72) Inventeur: **CARLACH, Jean-Claude**
**F-35000 Rennes (FR)**

(74) Mandataire: **Camolese, Marco et al**
**Metroconsult S.r.l.**
**Via Sestriere 100**
**10060 None (TO) (IT)**

(56) Documents cités:
**FR-A- 2 782 425**

• **CARLACH J ET AL: "A systematic construction of self-dual codes" IEEE TRANSACTIONS ON INFORMATION THEORY, IEEE, US, vol. 49, no. 11, 1 novembre 2003 (2003-11-01), pages 3005-3009, XP011103505 ISSN: 0018-9448**
• **CHIARALUCE F ET AL: "Extended Hamming Product Codes Analytical Performance Evaluation for Low Error Rate Applications" 1 novembre 2004 (2004-11-01), IEEE TRANSACTIONS ON WIRELESS COMMUNICATIONS, IEEE SERVICE CENTER, PISCATAWAY, NJ, US, PAGE(S) 2353 - 2361 , XP011124321 ISSN: 1536-1276 le document en entier**
• **CHIARALUCE F ET AL: "Some new results on extended hamming product codes and punctured product codes" 17 mai 2004 (2004-05-17), VEHICULAR TECHNOLOGY CONFERENCE, 2004. VTC 2004-SPRING. 2004 IEEE 59TH MILAN, ITALY 17-19 MAY 2004, PISCATAWAY, NJ, USA,IEEE, US, PAGE(S) 1033 - 1037 , XP010766068 ISBN: 9780780382558 le document en entier**

**Description**

**1. Domaine de l'invention**

Le domaine de l'invention est celui du codage de données numériques. Plus précisément, l'invention concerne les codes correcteurs d'erreurs.
L'invention s'applique notamment, mais non exclusivement, au codage de données source organisées en blocs de données indépendants les uns des autres, et devant donc être codés et décodés bloc par bloc, ainsi qu'au codage de flux de données (codage convolutif).

**2. Art antérieur**

De nombreuses techniques de codage permettant la correction d'erreurs de transmission sont déjà connues.
Ces codes correcteurs d'erreurs permettent de corriger les erreurs de transmission inhérentes à tout canal de communication. Ainsi, ils sont abondamment utilisés dans les domaines suivants :

- la transmission d'information par télécommunications filaires électriques, comme dans les normes ADSL, ou optiques, sur fibres optiques ou en espace libre ;
- la transmission d'information dans les communications radios spatiales et terrestres dites "sans-fils" (« wireless » en anglais) comme dans les systèmes de télévision numérique TNT, de radio numérique DAB, de téléphonie GSM ou UMTS, de réseau radio WiFi, et aussi dans tous les futurs systèmes de communications, comme les futures normes DVB, 4G, LTE, « Internet du futur », ou entre véhicules, objets ou machines communicants ... ;
- la compression et la décompression de source d'informations ;
- la génération et la détection de séquences dites d'embrouillage (« scrambling » en anglais) dans les systèmes CDMA ;
- le stockage d'informations dans des mémoires de masse magnétiques, optiques, mécaniques ou électriques pour constituer des disques "durs", ou des mémoires vives d'ordinateurs ou des "clés" mémoire à interface USB... ;
- la correction d'informations lors des calculs dans un circuit intégré d'un microprocesseur ou dans un ordinateur;
- etc.

Ces erreurs de transmission sont causées, par exemple, par le bruit thermique des composants électroniques du récepteur, des brouillages électromagnétiques (intentionnels ou non), des échos ou des propagations multiples dans le cas de la propagation hertzienne ou dans un réseau d'énergie électrique...
Pour pouvoir corriger ces erreurs de transmission, les codes correcteurs d'erreur permettent de générer des données de redondance à partir de données source.
Ainsi, un code correcteur d'erreur est classiquement défini par :

- une longueur $n$, correspondant aux données en sortie du codeur (mot de code de longueur $n$ formé de $k$ données source et de $(n - k)$ données de redondance),
- un nombre de bits ou de symboles d'information utiles $k$, correspondant aux données en entrée du codeur (encore appelées données source), et
- une distance minimale $d_{min}$.

La distance minimale d'un code $d_{min}$ correspond au minimum de distance entre deux mots de code. Elle permet de déterminer le nombre maximum d'erreurs que le code peut corriger dans un mot de code.
Le rendement du code est défini par $R = k/n$.
Par exemple, un code de Hamming (8, 4, 4) est un code de longueur $n = 8$, prenant en entrée $k = 4$ symboles d'information utiles, de distance minimale $d_{min} = 4$, et de rendement 1/2.
Les premières études sur les codes correcteurs d'erreurs datent des années 1940.
Plus récemment, dans le brevet européen EP 1 101 288, J.C. Carlach et C. Vervoux ont présenté un nouveau schéma de codage appelé « code Cortex ». Ces codes sont bien connus de l'homme du métier, et sont basés sur la construction d'un code présentant de bonnes propriétés de correction à partir de petits codes de base simples, mis en parallèle dans un certain nombre d'étages séparés par des permutations. L'article "A systematic Construction of Self-Dual Codes" de Jean-Claude Carlach et Ayoub Otmani IEEE TRANSACTIONS ON INFORMATION THEORY, IEEE, US, vol. 49, no. 11, 1 novembre 2003 (2003-11-01), pages 3005-3009, XP011103505 ISSN: 0018-9448, utilise une permutation c-cyclique différente de celle proposée à la revendication 1. De manière générale, un inconvénient des codes correcteurs d'erreur de longueur $n$ contenant $k$ symboles d'information utiles réside dans le fait que la distance minimale $d_{min}$ n'est pas optimale pour ces longueurs $n$ et $k$, c'est-à-dire que la distance minimale n'est pas la plus proche possible d'une borne supérieure pour laquelle le code permet de détecter le nombre maximum d'erreurs.

Or, le fait d'avoir une distance minimale $d_{min}$ la plus grande possible permet de détecter ($d_{min}$ - 1) symboles erronés et d'en corriger $\lfloor (d_{min} - 1) / 2 \rfloor$ (où l'opérateur $\lfloor . \rfloor$ désigne la partie entière).

De plus, pour un usage industriel, l'optimisation des codes correcteurs d'erreurs comprend également la minimisation des complexités de codage et de décodage en termes de coûts de matériel et d'énergie consommée.

Paradoxalement, ces problèmes d'optimisation des codes correcteurs d'erreurs sont plus difficiles à traiter quand les longueurs *n* des codes sont petites à moyennes, c'est-à-dire de l'ordre de *n* < 1000.

Ceci est dû au fait que l'algorithme classique appelé algorithme à propagation de probabilités (« Belief Propagation » en anglais), ou ses variantes, est de plus en plus sous-optimal au fur et à mesure que la longueur des cycles diminue.

Un cycle est un chemin fermé dans un graphe de Tanner représentant les contraintes (+ et = ) que doivent remplir les symboles d'un mot pour être un mot du code.

Il existe donc un besoin pour de nouveaux codes correcteurs d'erreurs présentant de très bons résultats (i.e une grande distance minimale), comme les codes Cortex, et présentant des cycles courts.

### 3. Exposé de l'invention

L'invention propose une solution nouvelle qui ne présente pas l'ensemble de ces inconvénients de l'art antérieur, sous la forme d'un dispositif de codage correcteur d'erreurs, du type associant des données de redondance à des données source, ledit dispositif comprenant:

- au moins trois étages de codage mettant en oeuvre chacun au moins un ensemble de trois modules de codage de base, dont un premier étage de codage, un dernier étage de codage et au moins un étage de codage intermédiaire, chaque module de codage mettant en oeuvre un code de base,
  chaque étage de codage recevant des données à traiter réparties entre les différents modules de codage de base et délivrant des données traitées issues desdits modules de codage de base,
  ledit premier étage de codage recevant lesdites données source et ledit dernier étage de codage délivrant lesdites données de redondance ; et
- au moins deux étages de permutation, lesdits étages de permutation étant insérés entre deux étages de codage successifs, dits étage de codage précédent et étage de codage suivant, et répartissant les données traitées issues de chaque module de codage de base de l'étage de codage précédent entre au moins deux modules de codage de base de l'étage de codage suivant. L'invention est caractérisée par la permutation de type c-cyclique qui s'écrit sous la forme particulière définie à la revendication 1. Selon l'invention, chaque module de codage de base comprend *c* entrées et *c* sorties, avec *c* un entier, et en ce que chaque étage de permutation met en oeuvre une permutation de type *c*-cyclique.

Ainsi, l'invention repose sur une approche nouvelle et inventive du codage correcteur d'erreurs, permettant d'obtenir, pour un rendement donné, un code performant dont la distance minimale est la plus grande possible, dont la mise en oeuvre est la plus simple possible, et permettant un décodage de complexité réduite.

En effet, les modules de codage de base sont choisis de telle manière que, combinés aux permutations de type c-cyclique, le code résultant est optimal et auto-dual.

Pour ce faire, les étages de codage sont au moins au nombre de trois et sont séparés par des permutations, choisies pour laisser un maximum de positions invariantes et pour comporter un nombre de cycles minimal.

L'utilisation de permutations c-cycliques permet notamment de minimiser le nombre d'opérations d'accès mémoire (lecture/écriture), et d'éviter les problèmes de conflit d'accès mémoire. En effet, la mémoire peut être partitionnée en c blocs, dans chacun desquels on peut stocker une donnée à une page mémoire ou un sous-bloc b d'adresse « modulo c ». Par exemple, pour une permutation 4-cyclique, on peut stocker les données $a_0, a_4, a_8$ dans un premier bloc, les données $a_1, a_5, a_9$ dans un deuxième bloc, les données $a_2, a_6, a_{10}$ dans un troisième bloc, et les données $a_3, a_7, a_{11}$ dans un quatrième bloc.

En particulier, lesdits codes de base appartiennent au groupe comprenant:

- un code de Hamming de matrice de transfert *P*;
- un demi-code de Hamming de matrice de transfert $P^+$ ou $P^-$, résultant d'un découpage en deux d'un code de Hamming de matrice de transfert *P*, tel que

$$P = P^+ \times P^- = P^- \times P^+ \; ;$$

- un demi-code à gauche tel que :

  - pour les indices pairs (2i) avec $0 \leq 2i \leq (c-1)$ : $r_{2i} = \sum_{j=-m}^{j=+m} x_{2i+j}$ , où $m = \left\lfloor \dfrac{\text{degré}}{2} \right\rfloor$ est l'opérateur somme modulo 2, encore appelé « OU exclusif », et où le degré correspond au nombre d'entrées des « OU exclusif » ;
  - pour les indices impairs (2i+1) avec $1 \leq 2i+1 \leq (c-1)$ :

$$r_{2i+1} = x_{2i+1},$$

  avec $r_i$ données de redondance et $x_i$ données source ;

- un demi-code à droite dual dudit demi-code à gauche tel que :

  - pour les indices pairs (2i) avec $0 \leq 2i \leq (c-1)$ :

$$r_{2i} = x_{2i},$$

  - pour les indices impairs (2i+1) avec $1 \leq 2i+1 \leq (c-1)$ : $r_{2i+1} = \sum_{j=-m}^{j=+m} x_{2i+1+j}$ , où $m = \left\lfloor \dfrac{\text{degré}}{2} \right\rfloor$ $\Sigma$ est l'opérateur

  somme modulo 2, encore appelé « OU exclusif », et où le degré correspond au nombre d'entrées des « OU exclusif » ;
  avec $r_i$ données de redondance et $x_i$ données source;

- un code identité.

Ainsi, les codes de base ont la propriété de mettre en oeuvre des codes auto-duaux, comme le code de Hamming et le code identité, ou des codes formant un code auto-dual lorsqu'ils sont concaténés, comme les demi-codes de Hamming gauche (de matrice de transfert $P^+$) et droit (de matrice de transfert $P^-$). Cette propriété d'auto-dualité permet un décodage optimal avec une complexité de décodage réduite. De plus, elle garantit notamment un rendement de codage égal à ½.

Selon une caractéristique particulière de l'invention, le dispositif de codage comprend au moins un étage de brassage postérieur, inséré entre deux étages de codage successifs, un étage de brassage postérieur comprenant deux sous-étages de brassage successifs, dits premier et deuxième sous-étages de brassage postérieur, mettant en oeuvre des brassages de type différent, ledit premier sous-étage de brassage postérieur comprend au moins deux modules de brassage distincts, chaque module de brassage recevant des données traitées issues d'au moins un ensemble de trois modules de codage d'un même étage de codage intermédiaire et délivrant des données brassées, prises en entrée dudit deuxième sous-étage de brassage postérieur, chaque module de brassage mettant en oeuvre des brassages de type différent, et le ledit dispositif comprend au moins un étage de brassage antérieur, inséré entre deux étages de codage successifs, un étage de brassage antérieur comprenant au moins un sous-étage de brassage antérieur mettant en oeuvre un brassage identique à un deuxième sous-étage de brassage postérieur d'un desdits étages de brassage postérieur.

Ainsi, le dispositif de codage correcteur d'erreurs selon l'invention permet, en ajoutant des étages de brassage avant et à la suite des étages imbriqués de permutations et de codage, d'obtenir des codes de longueur supérieure, qui conservent la propriété de distance minimale *dmin* la plus grande possible.

Par brassage, on entend ici tout type de distribution, permutation, rotation...

Selon un aspect particulier de l'invention, ledit étage de brassage antérieur comprend au moins deux sous-étages de brassage successifs, dits premier et deuxième sous-étages de brassage antérieur, mettant en oeuvre des brassages de type différent, et ledit deuxième sous-étage de brassage antérieur comprend au moins deux modules de brassage distincts, chaque module de brassage recevant des données brassées dudit premier sous-étage de brassage antérieur, et fournissant des données re-brassées à au moins un ensemble de trois modules de codage d'un même étage de codage intermédiaire, haque module de brassage mettant en oeuvre des brassages de type différent.

Ainsi, le choix des différents modules de brassage permet d'obtenir un code optimal de complexité réduite, à la fois au codage et au décodage.

L'utilisation de sous-modules de brassage superposés et de type différent permet d'obtenir une grande diversité de codes de base. En effet, les permutations en entrée et/ou en sortie des codes de base permettent d'obtenir des codes avec des combinaisons de symboles différentes. L'augmentation de la diversité des codes de base permet d'augmenter la distance minimale entre deux mots du code global résultant.

En particulier, lesdits modules de brassage ou sous-étages de brassage mettent en oeuvre un brassage appartenant au groupe comprenant :

- un brassage identité tel que :

$$\forall i = 0, 1, \ldots, (k\text{-}1) \quad \pi_k(i) = i \ ;$$

- un brassage tel que :

$$\forall i = 0, 1, \ldots, (k\text{-}1) \begin{cases} \pi_{\Delta,k}(i) = \Delta_0 + i (\mathrm{mod}\, k)\ si\ i \equiv 0\, (\mathrm{mod}\, c) \\ \pi_{\Delta,k}(i) = \Delta_1 + i (\mathrm{mod}\, k)\ si\ i \equiv 1\, (\mathrm{mod}\, c) \\ \cdot \qquad\qquad \cdot \\ \cdot \qquad\qquad \cdot \\ \cdot \qquad\qquad \cdot \\ \pi_{\Delta,k}(i) = \Delta_{c-1} + i (\mathrm{mod}\, k)\ si\ i \equiv (c-1)\, (\mathrm{mod}\, c) \end{cases} \ ;$$

avec pour conditions que $\Delta = \{\Delta_0, \Delta_1,\ldots,\Delta_{c\text{-}1}\}$ est un ensemble de paramètres entiers tels que :

- les paramètres $(\Delta_0,\Delta_1,\cdots,\Delta_{c\text{-}1})$ doivent prendre au moins trois valeurs différentes, ou
- si les paramètres $(\Delta_0,\Delta_1,\cdots,\Delta_{c\text{-}1})$ ne prennent que deux valeurs différentes alors chacune des deux valeurs est au moins présente deux fois dans l'ensemble $\Delta$,

- un brassage tel que :

$$\pi_{Bk}(i) = \left\lfloor \frac{i}{p} \right\rfloor + \mathrm{c} * (i \bmod p) \ \ \forall i = 0, 1, \ldots, (k\text{-}1), \ \text{avec}\ p = \left\lfloor \frac{k}{c} \right\rfloor,$$

avec $k$ la longueur de permutation.

Selon une caractéristique particulière de l'invention, tous lesdits modules de codage de base mettent en oeuvre un code de base identique.

Ainsi, le dispositif de codage correcteur d'erreurs selon l'invention est simplifié par l'utilisation de modules de codage de base mettant en oeuvre des codes de base identiques. En effet, l'implémentation technique des modules de codage se trouve simplifiée par la possibilité de réutiliser successivement des modules de codage mettant en oeuvre des codes identiques.

En particulier, ledit code de base identique est un code de Hamming de longueur $n$ égale à huit, comprenant $k$ égal à quatre symboles d'information utiles et de distance minimale $d_{min}$ égale à quatre.

Selon un aspect particulier de l'invention, c est un entier pair.

Selon une caractéristique particulière de l'invention, lesdits étages de permutation répartissent deux données traitées issues d'un module de codage de base d'un étage de codage précédent vers au moins deux modules de codage de base d'un étage de codage suivant.

Selon un aspect particulier de l'invention, ledit dispositif comprend un module de forçage à zéro, mettant à la valeur nulle au moins une desdites données source et/ou au moins une desdites données de redondance.

Ce « forçage » à zéro de certaines données en entrée et/ou en sortie des modules de codage de base permet notamment d'obtenir, de façon très flexible, des codes de rendement différent de ½ et dont les distances minimales restent bonnes, même lorsque le rendement tend vers 1. De même, on peut construire des codes quasi-optimaux avec des rendements tendant vers zéro. En effet, les données forcées à zéro au moment du codage représentent à la réception des informations nulles parfaites non-bruitées.

L'invention concerne également un procédé de codage correcteur d'erreurs, du type associant des données de redondance (r0 à r11) à des données source (x0 à x11), mettant en oeuvre :

- au moins trois étapes de codage dont une première étape de codage, une dernière étape de codage et au moins une étape de codage intermédiaire, mettant chacune en oeuvre au moins un ensemble de trois modules de codage de base,
  chaque module de codage mettant un oeuvre un code de base,
  chaque étape de codage recevant des données à traiter réparties entre les différents modules de codage de base et délivrant des données traitées issues desdits modules de codage de base,
  ladite première étape de codage recevant lesdites données source et ladite dernière étape de codage délivrant lesdites données de redondance ; et
- au moins deux étapes de permutation, lesdites étapes de permutation étant mises en oeuvre entre deux étapes de codage successives, dites étape de codage précédent et étape de codage suivant, et répartissant les données traitées issues de chaque module de codage de base mis en oeuvre dans l'étape de codage précédent entre au moins deux modules de codage de base mis en oeuvre dans l'étape de codage suivant. L'invention est caractérisée par la permutation de type c-cyclique qui s'écrit sous la forme particulière définie à la revendication 10. Selon l'invention, chaque module de codage de base comprend $c$ entrées et $c$ sorties, avec $c$ un entier, et en ce que chaque étape de permutation met en oeuvre une permutation de type $c$-cyclique.

Un tel procédé peut être mis en oeuvre par un dispositif de codage correcteur d'erreurs tel que décrit précédemment. Ce procédé se décline en différents mode de réalisation qui comportent respectivement les différentes caractéristiques relatives aux différents modes de réalisation du dispositif de codage correcteur d'erreurs selon l'invention.

Enfin, l'invention concerne également un programme d'ordinateur comportant des instructions pour la mise en oeuvre du procédé de codage correcteur d'erreurs tel que décrit précédemment lorsque ledit programme est exécuté par un processeur.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- la figure 1a illustre un exemple de module de codage de base selon un mode de réalisation du dispositif de codage correcteur d'erreurs de l'invention, représentant un codeur de Hamming compact C4 ;
- la figure 1b illustre la matrice de transfert P du codeur de la figure 1a;
- les figures 2a et 2b illustrent deux exemples de module de codage de base selon un mode de réalisation du dispositif de codage correcteur d'erreurs de l'invention, représentant respectivement un demi-codeur de Hamming à gauche C4$^+$ et un demi-codeur de Hamming à droite C4$^-$;
- les figures 2c, 2d et 2e illustrent trois exemples de module de codage de base selon un mode de réalisation du dispositif de codage correcteur d'erreurs de l'invention, représentant respectivement des demi-codes à 5, 6 et 7 entrées ;
- la figure 3a illustre un premier mode de réalisation du dispositif de codage correcteur d'erreurs selon l'invention, comprenant trois étages de codage comprenant chacun trois modules de codage de base mettant en oeuvre un code de Hamming compact C4, et deux étages de permutation $\pi0$;
- la figure 3b présente la matrice de transfert P du codeur de la figure 3a ;
- la figure 4a illustre un deuxième mode de réalisation du dispositif de codage correcteur d'erreurs selon l'invention, comprenant trois étages de codage comprenant chacun trois modules de codage de base mettant en oeuvre un code de Hamming compact C4, un demi-code de Hamming à gauche C4$^+$, un demi-code de Hamming à droite C4$^-$ ou un code identité de longueur quatre, et deux étages de permutation $\pi0$;
- la figure 4b présente la matrice de transfert P du codeur de la figure 4a ;
- la figure 5a illustre un troisième mode de réalisation du dispositif de codage correcteur d'erreurs selon l'invention, comprenant trois étages de codage comprenant chacun quatre modules de codage de base mettant en oeuvre un code de Hamming compact C4, et deux étages de permutation $\pi0$;
- la figure 5b présente la matrice de transfert P du codeur de la figure 5a;
- la figure 6a illustre un quatrième mode de réalisation du dispositif de codage correcteur d'erreurs selon l'invention, comprenant cinq étages de codage comprenant chacun six modules de codage de base mettant en oeuvre un code de Hamming compact C4, deux étages de permutation $\pi0$, un étage de brassage antérieur $\pi$-1 et un étage de brassage postérieur π1 ;
- la figure 6b présente la matrice de transfert P du codeur de la figure 6a ;
- la figure 7a illustre un cinquième mode de réalisation du dispositif de codage correcteur d'erreurs selon l'invention, comprenant cinq étages de codage comprenant chacun neuf modules de codage de base mettant en oeuvre un code de Hamming compact C4, deux étages de permutation π0, un étage de brassage antérieur π-1 et un étage de brassage postérieur π1 ;
- la figure 7b présente la matrice de transfert P du codeur de la figure 7a ;
- la figure 8a illustre un sixième mode de réalisation du dispositif de codage correcteur d'erreurs selon l'invention, comprenant sept étages de codage comprenant chacun douze modules de codage de base mettant en oeuvre un code de Hamming compact C4, deux étages de permutation π0, deux étages de brassage antérieur π-2 et π-1 et deux étages de brassage postérieur π1 et π2;
- la figure 8b présente la matrice de transfert P du codeur de la figure 8a ;
- la figure 9 illustre les principales étapes d'un procédé de codage selon un mode de réalisation de l'invention.

## 5. Description d'un mode de réalisation de l'invention

### 5.1 Principe général

Le principe général de l'invention repose sur l'association de modules de codage de base et de permutations de type c-cyclique, les modules de codage de base étant choisis de telle manière que, combinés aux permutations de type c-cyclique, le code résultant est optimal et auto-dual.

On peut notamment juxtaposer, en série et/ou en parallèle, ces permutations de type c-cyclique, des permutations de graphes bipartis complets et des permutations identité.

On rappelle qu'un code est dit « auto-dual » s'il est égal à son dual. En d'autres termes, tout mot $u$ d'un code auto-dual est orthogonal à tout autre mot $v$ du code, y compris lui-même. Ainsi, $u.v=0$, avec un produit scalaire u.v dans le corps ou l'anneau des symboles du code, c'est-à-dire par exemple modulo2.

Pour ce faire, les étages de codage sont au moins au nombre de trois et sont séparés par des permutations spécifiques, choisies pour laisser un maximum de positions invariantes et pour comporter un nombre de cycles minimal. Les codes mis en oeuvre par les modules de codage de base sont également spécifiques, et appartiennent au groupe comprenant les codes de Hamming, les demi-codes de Hamming tels que définis ci-après, ou les codes identité.

L'invention propose donc une nouvelle structure de codeur correcteur d'erreurs, permettant d'obtenir, pour un rendement donné, un code dont la distance minimale est la plus grande possible, dont la mise en oeuvre est la plus simple possible, et permettant un décodage de complexité réduite, c'est-à-dire une factorisation des calculs lors du codage et du décodage grâce à une factorisation des matrices P de transfert du code obtenu selon l'invention.

Elle permet ainsi de simplifier l'implantation des codeurs Cortex existants, tels que définis dans le brevet européen EP 1 101 288 précité. Cette amélioration des codes Cortex permet notamment de définir de nouveaux codes, comme les codes auto-duaux optimaux ($n=48$, $k=24$) et ($n=72$, $k=36$), qui peuvent eux-mêmes devenir des codes de base pour construire de nouveaux codes plus longs, selon le principe récursif de l'invention.

Un codeur correcteur d'erreurs selon l'invention peut trouver des applications dans un grand nombre de domaines, et notamment dans les domaines listés en relation avec l'art antérieur.

### 5.2 Définitions

#### 5.2.1 Code de Hamming compact et demi-codes de Hamming à gauche et à droite

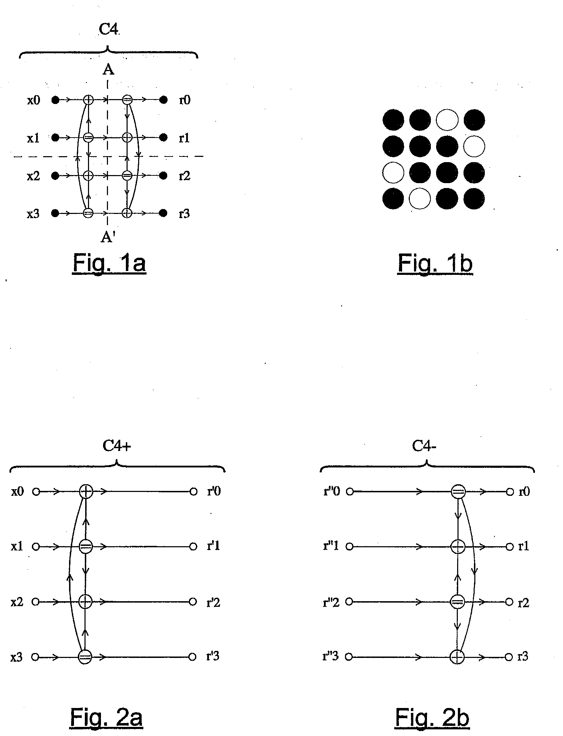

La figure 1a illustre une représentation particulière d'un code de Hamming (8, 4, 4), dit code de Hamming compact C4, qui peut être mis en oeuvre dans un module de codage de base selon un mode de réalisation du dispositif de codage correcteur d'erreurs de l'invention.

Ce module de codage de base comprend quatre entrées x0, x1, x2 et x3 (ce = 4), correspondant à des données source, et quatre sorties r0, r1, r2 et r3, (cs = 4) correspondant à des données de redondance, calculées de la manière suivante :

$$r0 = x0 + x1 + x3$$

$$r1 = x0 + x1 + x2$$

$$r2 = x1 + x2 + x3$$

$$r3 = x0 + x2 + x3$$

La matrice de transfert P de ce code de Hamming compact est illustrée en figure 1b, où les ronds blancs correspondent à 0 et les ronds noirs correspondent à 1.

Le polynôme énumérateur des poids des lignes de cette matrice de transfert P est égal à $W_p(X) = 4X^3$, avec un poids minimal $w_{min}$ = 3 et une distance minimale $d_{min}$ = 4.

Ce code de base est auto-dual. Il permet donc de garantir un rendement de ½.

Du fait de la représentation spécifique adoptée, le code dual de ce code de base peut s'obtenir facilement en remplaçant les opérations d'addition («+») par des opérations d'égalité («=»), et les opérations d'égalité («=») par des opérations d'addition (« + »), et en inversant le sens des flèches. Cette représentation est donc avantageuse.

Cette représentation spécifique permet également de construire deux nouveaux codes pouvant être utilisés dans les modules de codage de base, en découpant le code de Hamming compact ainsi représenté en deux, en suivant l'axe (AA') de la figure 1a. On obtient de cette façon deux codes plus petits, appelés demi-code de Hamming à gauche, noté C4⁺, et demi-code de Hamming à droite, noté C4⁻.

Le demi-code de Hamming à gauche C4⁺ est associé à une matrice de transfert *P⁺* et le demi-code de Hamming à droite C4⁻ à une matrice de transfert *P⁻* telles que

$$P = P^+ \times P^- = P^- \times P^+.$$

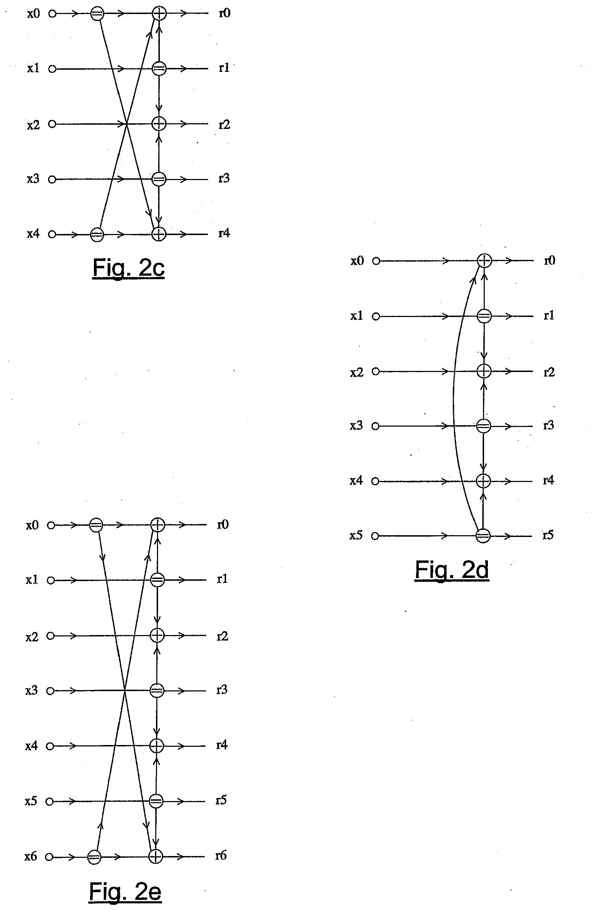

Ces deux demi-codes sont illustrés respectivement en figures 2a et 2b.

Plus précisément, selon cet exemple, le demi-code à gauche C4⁺ comporte quatre bits d'entrée (x0, x1, x2, x3) (ce = 4) et quatre bits de sortie (r'0, r'1, r'2, r'3) (cs = 4).

Le demi-code à droite C4- comporte quatre bits d'entrée (r"0, r"1, r"2, r"3) (ce = 4) et quatre bits en sortie (r0, r1, r2, r3) (cs = 4).

Le demi-code à droite C4⁻ est le code dual du demi-code à gauche C4⁺ (primal), avec (ce) = (cs) = 4.

Ces deux demi-codes à gauche C4⁺ et à droite C4⁻ peuvent être regroupés en connectant directement les sorties (r'0, r'1, r'2, r'3) du demi-code à gauche C4⁺ aux entrées (r"0, r"1, r"2, r"3) du demi-code à droite C4⁻, pour former un code de Hamming compact C4.

Selon cet exemple, le demi-code à gauche du code de Hamming C4 est défini par un motif ou « pattern » 2-cyclique tel que:

$$x(2i-1) + x(2i) + x(2i+1) \text{ donne } r'(i)$$

et

$$x(2i+1) \text{ donne } r'(2i+1),$$

avec les indices i calculés modulo la longueur (ce), soit quatre pour le code de Hamming C4(8,4,4).

Ainsi :

- pour i = 0 :

$$r'0 = x(-1) + x(0) + x(1) = x3 + x0 + x1$$

$$r'1 = x1$$

- pour i = 1 :

$$r'2 = x(1) + x(2) + x(3) = x1 + x2 + x3$$

$$r'3 = x3.$$

Dans d'autres modes de réalisation, on peut avoir des codes de base présentant un nombre d'entrées (ce) différent du nombre de sorties (cs).

De même, cette représentation « compacte » du code de Hamming peut être étendue à un nombre d'entrées ou de sorties différent de quatre.

Une formule générale permettant de construire des demi-codes de base à gauche, et à droite, ayant c entrées et sorties, peut s'exprimer de la façon suivante:

- pour les indices pairs (2i) avec $0 \le 2i \le (c-1)$: $r_{2i} = \sum_{j=-m}^{j=+m} x_{2i+j}$, où $m = \left\lfloor \dfrac{\text{degré}}{2} \right\rfloor$ $\Sigma$ est l'opérateur somme modulo 2, encore appelé «OU exclusif », et où le degré correspond au nombre d'entrées des «OU exclusif» (le degré est toujours impair) ;

- pour les indices impairs (2i+1) avec $1 \le 2i+1 \le (c-1)$:

$$r_{2i+1} = x_{2i+1}.$$

Par exemple, on peut construire un demi-code à cinq entrées et cinq sorties, illustré en figure 2c, tel que :

$$r0 = x4 + x0 + x1$$

$$r1 = x1$$

$$r2 = x1 + x2 + x3$$

$$r3 = x3$$

$$r4 = x3 + x4 + x0$$

Ou encore, un demi-code à six entrées et six sorties, comme illustré en figure 2d, peut être obtenu et exprimé de la manière suivante :

$$r0 = x5 + x0 + x1$$

$$r1 = x1$$

$$r2 = x1 + x2 + x3$$

$$r3 = x3$$

$$r4 = x3 + x4 + x5$$

$$r5 = x5$$

Un autre exemple de demi-code est illustré en figure 2f. Il comprend sept entrées et sept sorties, et s'exprime ainsi :

$$r0 = x6 + x0 + x1$$

$$r1 = x1$$

$$r2 = x1 + x2 + x3$$

$$r3 = x3$$

$$r4 = x3 + x4 + x5$$

$$r5 = x5$$

$$r6 = x5 + x6 + x0$$

### 5.2.2 Permutation de type c-cyclique $\pi_{\Delta,k}$

Une permutation de type c-cyclique est une permutation invariante pour les positions multiples de c. En d'autres termes, un même motif de permutation est appliqué pour chaque bloc de longueur c.

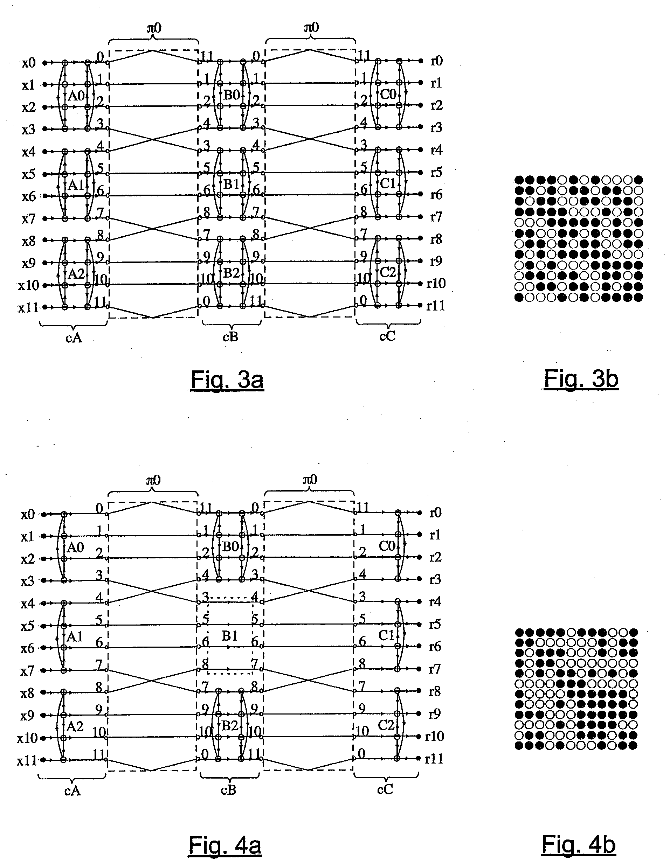

Par exemple, on considère une permutation de type 4-cyclique, comme illustrée en figure 3a, prenant en entrée des symboles aux positions 0, 1, 2, 3, 4, 5, 6, 7, 8, 9, 10 et 11, et délivrant ces mêmes symboles aux positions 11, 1, 2, 4, 3, 5, 6, 8, 7, 9, 10 et 0 respectivement. On constate, selon un premier motif de permutation, que les symboles aux positions (1, 2, 3,4) sont envoyés sur les positions (1, 2, 4, 3), les symboles aux positions (5, 6, 7, 8) sont envoyés sur les positions (5, 6, 8, 7), et les symboles aux positions (9, 10, 11, 0) sont envoyés sur les positions (9, 10, 0, 11). Les symboles aux positions (i, i+1, i+2, i+3) sont donc envoyés sur les positions (i, i+1, i+3, i+2) selon ce premier motif. Selon un autre motif de permutation, les symboles aux positions (2, 3, 4, 5) sont envoyés sur les positions (2, 4, 3, 5), les symboles aux positions (6, 7, 8, 9) sont envoyés sur les positions (6, 8, 7, 9), et les symboles aux positions (10, 11, 0, 1) sont envoyés sur les positions (10, 0, 11,1). Les symboles aux positions (i, i+1, i+2, i+3) sont donc envoyés sur les positions (i, i+2, i+1, i+3) selon ce deuxième motif.

On respecte donc un même motif de permutation pour chaque bloc de longueur c = 4.

Une permutation de type c-cyclique peut s'écrire sous la forme :

$$\forall i = 0, 1, ..., (k\text{-}1) \begin{cases} \pi_{\Delta,k}(i) = \Delta_0 + i(\bmod k) \, si \, i \equiv 0 \, (\bmod c) \\ \pi_{\Delta,k}(i) = \Delta_1 + i(\bmod k) \, si \, i \equiv 1 \, (\bmod c) \\ \cdot \qquad \cdot \\ \cdot \qquad \cdot \\ \cdot \qquad \cdot \\ \pi_{\Delta,k}(i) = \Delta_{c-1} + i(\bmod k) \, si \, i \equiv (c-1)(\bmod c) \end{cases},$$

avec $\Delta = \{\Delta_0, \Delta_1, ..., \Delta_{c-1}\}$ un ensemble de paramètres entiers (ajouté ou retranché de l'indice d'un symbole de sortie de la permutation c-cyclique afin de trouver l'indice de ce symbole à l'entrée de la permutation). Les restrictions suivantes doivent être appliquées à l'ensemble $\Delta$ des paramètres entiers :

1. les paramètres $(\Delta_0, \Delta_1, \cdots, \Delta_{c-1})$ d'un ensemble $\Delta$ doivent prendre au moins trois valeurs différentes. Par exemple, pour le cas c=4: $(\Delta_0, \Delta_1, \Delta_2, \Delta_3) = (-1,0,0,+1)$ et

2. par exception, dans le cas où les paramètres $(\Delta_0, \Delta_1, \cdots, \Delta_{c-1})$ d'un ensemble $\Delta$ ne prennent que deux valeurs différentes alors chacune des deux valeurs est au moins présente deux fois dans l'ensemble. Par exemple, pour le cas c = 4 $(\Delta_0, \Delta_1, \Delta_2, \Delta_3) = (-1,-1,+1,+1)$ permet de définir une permutation 4-cyclique alors que $(\Delta_0, \Delta_1, \Delta_2, \Delta_3) = (n,0,0,0)$, avec $n$ entier relatif non nul, est exclu car la valeur « $n$ » n'est présente qu'une fois dans l'ensemble $\Delta$. Un tel quadruplet ne donne pas de bons codes globaux (avec une grande distance minimale) avec un minimum d'étages.

L'utilisation de cette permutation c-cyclique permet de simplifier la mise en oeuvre du dispositif de codage correcteur d'erreurs, en diminuant le nombre de composants à utiliser.

De plus, cette permutation de type c-cyclique permet de limiter les accès en mémoire, pour les bits invariants, qui sont laissés à leur place mémoire. Les calculs d'adresse sont également minimisés, car les adresses des données non utiles sont réutilisées.

### 5.2.3 Permutation de graphes bipartis complets $\pi_{Bk}$

Ces permutations ont un rôle de mélange ou brassage d'informations, en entrée ou en sortie des modules de codage de base.

Une telle permutation peut s'écrire sous la forme :

$$\pi_{Bk}(i) = \left\lfloor \frac{i}{p} \right\rfloor + c * (i \bmod p) \quad \forall i = 0, 1, ..., (k\text{-}1), \text{ avec } p = \left\lfloor \frac{k}{c} \right\rfloor,$$

(où l'opérateur $\llcorner \lrcorner$ désigne la partie entière).

### 5.3 Description d'un premier mode de réalisation

On présente maintenant, en relation avec les figures 3a et 3b, un premier mode de réalisation du dispositif de codage selon l'invention.

La figure 3a illustre la structure d'un codeur selon l'invention, prenant en entrée des données source (x0, x1, x2 ... x11) et délivrant en sortie des données de redondance (r0, r1, r2 ... r11).

Ces données de redondance peuvent ensuite être utilisées, en combinaison avec les données source, pour former un mot de code.

Le codeur ainsi réalisé comprend trois étages de codage cA, cB et cC, et deux étages de permutation $\pi 0$. Chaque étage de codage comprend trois modules de codage de base : (A0, A1, A2) pour le premier étage de codage cA, (B0 B1, B2) pour l'étage de codage intermédiaire cB et (C0, C1, C2) pour le dernier étage de codage cC.

Les nombres indiqués en entrée et en sortie des étages de permutations $\pi 0$ définissent la position des symboles en entrée d'un étage de permutation et leur position correspondante en sortie.

Selon ce premier mode de réalisation, chaque module de codage de base correspond au codeur C4 illustré en figure 1a, mettant en oeuvre un code de Hamming compact comme décrit ci-dessus.

De plus, les permutations $\pi 0$ utilisées sont des permutations de type 4-cyclique, de paramètre $\Delta=1$ (ce qui permet de limiter les « croisements »), qui sont décrites par un nombre minimum de cycles et donc un nombre maximum de positions invariantes (représentées par les traits horizontaux dans les étages de permutation), ce qui réduit les calculs et les accès mémoire.

Ce codeur permet d'obtenir un code de longueur $n$ égale à 24, avec $k$ égal à 12 symboles d'information utiles et une distance minimale $dmin$ égale à 8.

L'utilisation de code de Hamming C (8, 4, 4) dans l'ensemble des modules de codage de base permet notamment d'obtenir une borne supérieure de la distance minimale pour le code final construit qui atteint la borne minimale Bmin, définit par :

$$d_{\min} \le B\min = 4\left\lfloor \frac{n}{24} \right\rfloor + 4 .$$

Ce code obtenu par une construction Cortex selon l'invention, est appelé par la suite code Cortex-Golay (24, 12, 8) « simplifié ». En d'autres termes, l'invention permet de reconstruire un code de Golay en utilisant une structure simplifiée à base de codes de Hamming.La matrice P de transfert du code final obtenu est illustrée en figure 3b.

Le polynôme énumérateur des poids des lignes de cette matrice P est égal à : $W_p(X) = 12X^7$, avec un poids minimal $w_{min} \le 7$ et une distance minimale $d_{min} \le 8$.

Les lignes de poids minimales $w_{min}$ permettent d'indiquer la distance minimale $d_{min}$ des codes construits selon l'invention, de la façon suivante :

$$d_{min} \le (w_{min} + 1).$$

Cette propriété est très rare pour une famille de codes, dont il devient particulièrement. simple de calculer la distance minimale $d_{min}$ à partir de la longueur $n$, multiple de 24, du code. En effet, il suffit de calculer le poids des $k$ lignes de la matrice de transfert P du code, au lieu de calculer de façon exhaustive les $2^k$ mots du code.

*5.4 Description d'un deuxième mode de réalisation*

On présente maintenant, en relation avec les figures 4a et 4b, un deuxième mode de réalisation du dispositif de codage selon l'invention.

La figure 4a illustre un codeur selon l'invention, prenant en entrée les données (x0, x1, x2 ... x11) et délivrant en sortie les données de redondance (r0, r1, r2 ... r11). De nouveau, ces données de redondance peuvent être utilisées en combinaison avec les données source pour former un mot de code.

Le codeur ainsi réalisé comprend trois étages de codage cA, cB et cC, et deux étages de permutation $\pi0$. Chaque étage de codage comprend trois modules de codage de base; le premier étage de codage cA met en oeuvre trois demi-codes de Hamming à gauche $C4^+$ (A0, A1, A2), l'étage de codage interémdiaire cB met en oeuvre deux codes de Hamming compact C4 (B0, B2) et un code identité Id4, le dernier étage de codage cC met en oeuvre trois demi-codes de Hamming à droite $C4^-$ (C0, C1, C2).

Comme dans le mode de réalisation précédemment décrit, les permutations $\pi0$ utilisées sont des permutations de type 4-cyclique, de paramètre $\Delta=1$, qui sont décrites par un nombre minimum de cycles et donc un nombre maximum de positions invariantes (représentées par les traits horizontaux dans les étages de permutation), ce qui réduit les calculs et les accès mémoire.

En revanche, dans ce mode de réalisation, les étages de codage ne mettent pas tous en oeuvre des codes de même type.

En effet, le premier étage de codage cA comprend trois modules de codage de base (A0, A1, A2) mettant chacun en oeuvre un code de type demi-code de Hamming à gauche $C4^+$, tel que décrit précédemment.

Ce demi-code de Hamming à gauche n'est pas auto-dual, aussi, afin de conserver cette propriété au code « global » ou final construit, le dernier étage de codage cC comprend également trois modules de codage de base (C0, C1, C2) mettant chacun en oeuvre un code de type demi-code de Hamming à droite $C4^-$.

L'assemblage de ces deux étages de codage cA et cC comprenant des modules de codage de base mettant en oeuvre des demi-codes de Hamming à gauche et à droite est équivalent à un étage de codage comprenant des modules de codage de base mettant en oeuvre des codes de Hamming compact.

L'utilisation de demi-codes de Hamming à gauche et à droite permet une plus grande souplesse dans la construction du code final, et permet en particulier d'obtenir un plus grand nombre de codes.

L'étage de codage intermédiaire cB comprend quant à lui deux modules de codage de base (B0 B2) mettant en oeuvre un code de Hamming compact C4, et un module de codage de base mettant en oeuvre un code identité Id4.

Cette diversité de codes de base C4+, C4, Id4 et C4-, permet de construire pratiquement tous les codes auto-duaux, optimaux mais aussi ceux qui ne sont pas optimaux. Cependant, le choix est fait en fonction du poids minimal des lignes de leurs matrices de transfert P, qui donne une borne des poids des mots non-nuls du code.

Ce codeur met en oeuvre le même motif de permutation $\pi0$ de type 4-cyclique que celui décrit dans le mode de réalisation précédent, c'est-à-dire une permutation de type 4-cyclique et de paramètre $\Delta=1$.

La matrice P de transfert de ce code est illustrée en figure 4b.

Le polynôme énumérateur des poids des lignes de cette matrice P est égal à : $Wp(X) = 2X^3 + 2X^5 + 6X^7 + 2X^9$, avec un poids minimal $w_{min} = 3$ et une distance minimale $d_{min} \le 4$.

*5.5 Description d'un troisième mode de réalisation*

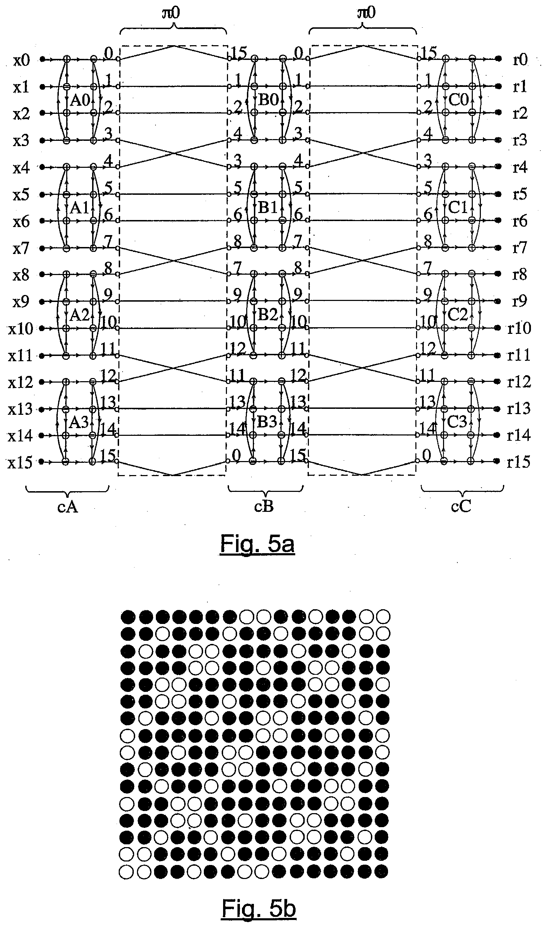

On présente maintenant, en relation avec les figures 5a et 5b, un troisième mode de réalisation du dispositif de codage selon l'invention.

La figure 5a illustre un tel codeur selon l'invention, prenant en entrée les données (x0, x1, x2 ... x15) et délivrant en sortie les données de redondance (r0, r1, r2 ... r15).

Le codeur ainsi réalisé comprend trois étages de codage cA, cB et cC, comprenant chacun quatre modules de codage de base (A0, A1, A2, A3), (B0 B1, B2, B3) et (C0, C1, C2, C3) mettant chacun en oeuvre un code de Hamming compact C4, et deux étages de permutation $\pi 0$.

Ce codeur met en oeuvre le même motif de permutation $\pi 0$ de type 4-cyclique que celui décrit dans le premier mode de réalisation, c'est-à-dire une permutation de type 4-cyclique et de paramètre $\Delta=1$.

La longueur de ce code est égale à 32, soit 4/3 de la longueur du code Cortex-Golay $C_1(24, 12, 8)$ « simplifié » décrit ci-dessus, et la distance minimale $d_{min}$ de ce code est identique à celle du code Cortex-Golay $C_1(24,12,8)$ « simplifié » décrit ci-dessus.

L'invention permet donc de dériver, à partir d'un code de construction Cortex, un code Cortex plus long ayant la même distance minimale $d_{min}$.

La matrice P de transfert de ce code est illustrée en figure 5b.

Le polynôme énumérateur des poids des lignes de cette matrice P est égal à : $W_p(X) = 16X^{11}$, avec un poids minimal $w_{min} = 11$ et une distance minimale $d_{min} \le 12$. Cependant, ce code étant dérivé du code Cortex-Golay $C_1(24, 12,8)$ « simplifié » décrit ci-dessus, on a $d_{min} = 8$.

*5.6 Description d'un quatrième mode de réalisation*

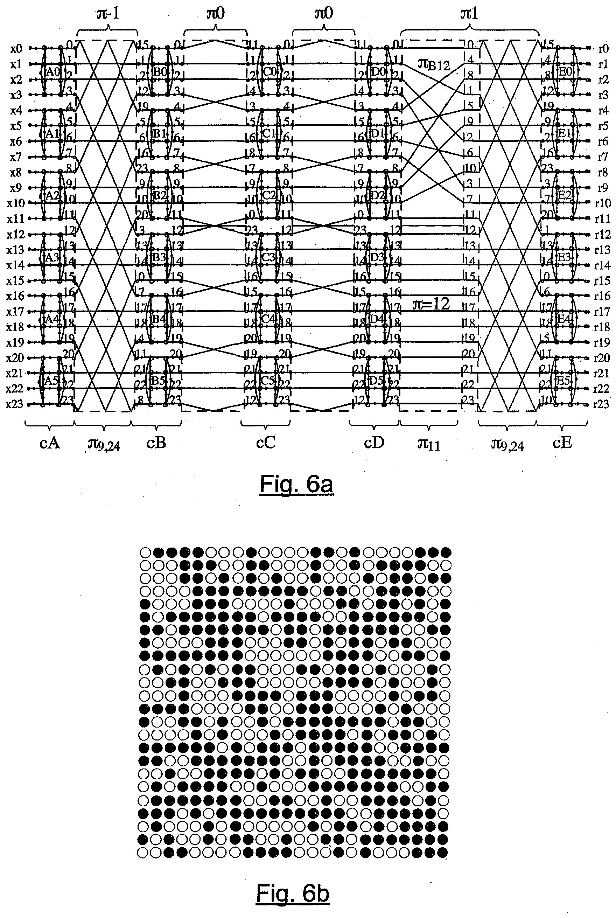

On présente maintenant, en relation avec les figures 6a et 6b, un quatrième mode de réalisation du dispositif de codage selon l'invention.

La figure 6a illustre un codeur selon l'invention, prenant en entrée les données (x0, x1, x2 ... x23) et délivrant en sortie les données de redondance (r0, r1, r2 ... r23).

Le codeur ainsi réalisé comprend cinq étages de codage cA, cB, cC, cD et cE, comprenant chacun six modules de codage de base (A0, A1, A2, A3, A4, A5), (B0, B1, B2, B3, B4, B5), (C0, C1, C2, C3, C4, C5), (D0, D1, D2, D3, D4, D5) et (E0, E1, E2, E3, E4, E5) mettant chacun en oeuvre un code de Hamming compact C4, deux étages de permutation $\pi 0$, un étage de brassage antérieur $\pi-1$(noté également $\pi_{9,24}$) et un étage de brassage postérieur $\pi 1$, lui-même composé de deux sous-étages de brassage $\pi 11$ et $\pi_{9,24}$. Le premier sous-étage de brassage postérieur $\pi 11$ comprend deux modules de brassage distincts, notés $\pi_{B12}$ et $\pi$=12, mettant en oeuvre des brassages distincts.

On peut remarquer que ce codeur comporte deux codeurs mettant en oeuvre des codes appelés précédemment code Cortex-Golay $C_1(24, 12, 8)$ « simplifié », identifiés sur la figure 6a respectivement par les modules de codage de base (B0 B1, B2), (C0, C1, C2), (D0, D1, D2) pour le codeur Cortex-Golay $C_1(24, 12, 8)$ du haut, et (B3, B4, B5), (C3, C4, C5), (D3, D4, D5) pour le codeur Cortex-Golay $C_1(24, 12, 8)$ du bas, et les permutations $\pi 0$ (de type 4-cyclique et de paramètre $\Delta=1$).

De plus, les sorties du codeur Cortex-Golay $C_1(24, 12, 8)$ du haut entrent sur le premier module de brassage $\pi_{B12}$, mettant en oeuvre le brassage suivant :

$$\pi_{Bk}(i) = \left\lfloor \frac{i}{p} \right\rfloor + 4 * (i \bmod p) \quad \forall i = 0, 1, \ldots, (k\text{-}1), \text{ avec } p = \left\lfloor \frac{k}{4} \right\rfloor.$$

Par exemple, pour *k* égal à 12, comme illustré en figure 6a, *p* est égal à 3 et on obtient les positions suivantes en sorties du premier module de brassage : $\pi_{B12}$ = {0, 4, 8, 1, 5, 9, 2, 6, 10, 3, 7, 11}.

Les sorties du codeur Cortex-Golay $C_1(24, 12, 8)$ du bas entrent quant à elles sur le deuxième module de brassage $\pi$=12, mettant en oeuvre un brassage identité, c'est-à-dire une absence de brassage.

L'utilisation de ces deux types de brassage distincts, dans un même sous-étage de brassage $\pi 11$ de l'étage de brassage postérieur $\pi 1$, est fondamentale pour obtenir une grande diversité de codes résultants.

Le deuxième sous-étage de brassage $\pi_{9,24}$ de l'étage de brassage postérieur $\pi 1$ met en oeuvre une permutation de type 4-cyclique de paramètre $\Delta$ égal à 9 et de longueur *k* égale à 24.

L'étage de brassage antérieur $\pi-1$ met également en oeuvre une permutation de type 4-cyclique de paramètre $\Delta$ égal à 9 et de longueur *k* égale à 24.

On peut ainsi exprimer les différentes permutations mises en oeuvre dans la construction de ce codeur, noté codeur Cortex $C_2(48, 24)$, de la manière suivante :

$$\Pi(C_2) = \left\{ \pi_{9,24}, \pi_{1,12} * \pi_{1,12}, \pi_{1,12} * \pi_{1,12}, (\pi_{B12} * \pi_{=12}) \circ \pi_{9,24} \right\},$$

ou, avec une notation simplifiée : $C_2 = (C_1 * C_1, \Delta_1 = 9)$,
avec l'opérateur superposant des permutations et l'opérateur concaténant des permutations.

On entend par superposer (en parallèle) deux permutations le fait de les disposer verticalement les unes au dessous des autres, c'est-à-dire les mettre en parallèle. Par exemple, la superposition, ou la mise en parallèle de deux permutations identités Id4={0,1,2,3} donne une permutation identité Id8, telle que :

Id4*Id4=Id8, c'est à dire {0,1,2,3}*{0,1,2,3} = {0,1,2,3,4,5,6,7}.

On entend par concaténer (en série) deux permutations le fait de les disposer horizontalement, c'est-à-dire les mettre en série. Par exemple, la concaténation, ou la mise en série de deux permutations $\pi0$={1,2,3,0} et $\pi1$={3,0,1,2} donne une permutation identité Id4, telle que :

$\pi0 \circ \pi1$= Id4, c'est-à-dire {1,2,3,0} o {3,0,1,2} = {0,1,2,3}.

La matrice P de transfert de ce code Cortex $C_2$(48, 24) est illustrée en figure 6b.
Le polynôme énumérateur des poids des lignes de cette matrice P est égal à : $W_p(X) = 12X^{11} + 8X^{15} + 4X^{19}$, avec un poids minimal $w_{min}$ = 11 et une distance minimale $d_{min} \leq 12$.

*5.7 Description d'un cinquième mode de réalisation*

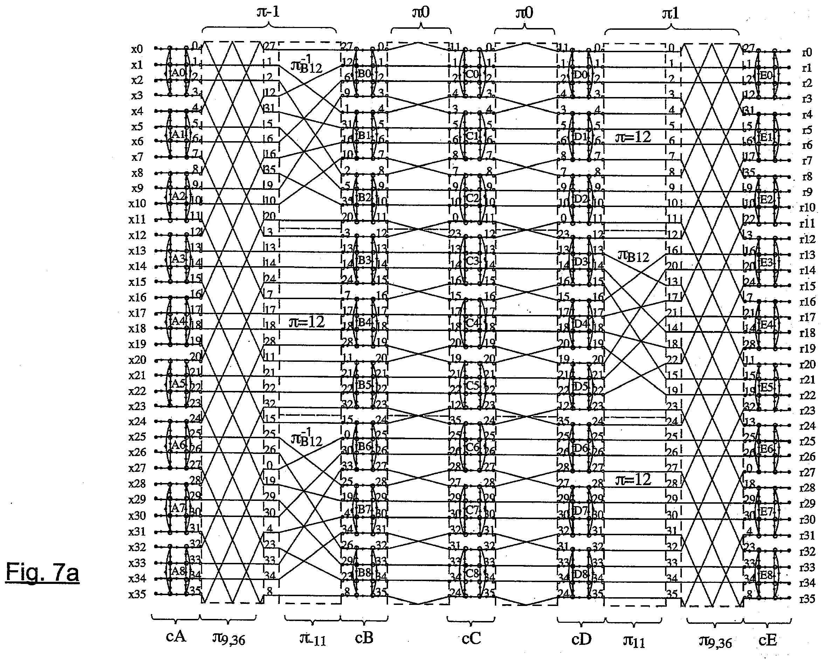

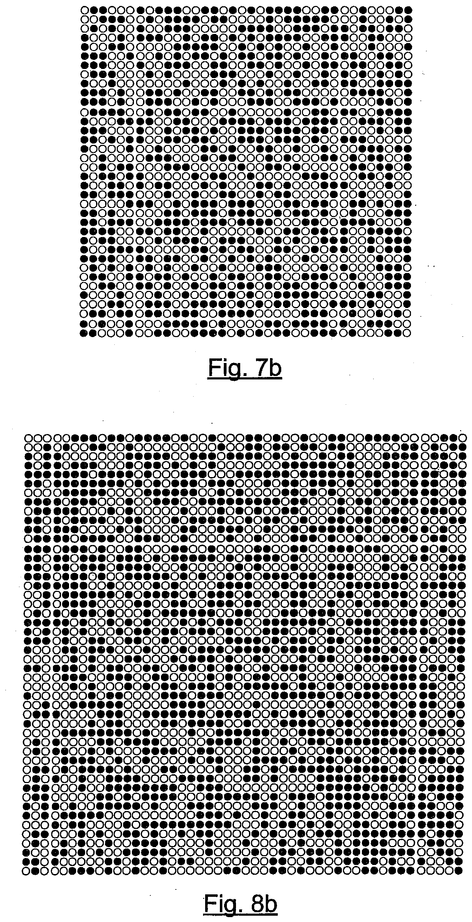

On présente maintenant, en relation avec les figures 7a et 7b, un cinquième mode de réalisation du dispositif de codage selon l'invention.
La figure 7a illustre un codeur selon l'invention, prenant en entrée les données (x0, x1, x2 ... x35) et délivrant en sortie les données de redondance (r0, r1, r2 ... r35).
Le codeur ainsi réalisé comprend cinq étages de codage cA, cB, cC, cD et cE, comprenant chacun neuf modules de codage de base (A0...A8), (B0...B8), (C0...C8), (D0...D8), (E0...E8) mettant chacun en oeuvre un code de Hamming compact C4, deux étages de permutation $\pi0$, un étage de brassage antérieur $\pi$-1 et un étage de brassage postérieur $\pi1$.
L'étage de brassage antérieur $\pi$-1 comprend deux sous-étages de brassage antérieur, notés respectivement $\pi_{9,36}$ et $\pi$-11.
Le deuxième sous-étage de brassage antérieur $\pi$-11 comprend trois modules de brassage, dont deux modules mettant en oeuvre un brassage noté $\pi_{B12}^{-1}$, et un module mettant en oeuvre un brassage identité $\pi_{=12}$.
L'étage de brassage postérieur $\pi1$ comprend deux sous-étages de brassage postérieur, notés respectivement $\pi11$ et $\pi_{9,36}$.
Le premier sous-étage de brassage postérieur $\pi11$ comprend trois modules de brassage, dont deux modules mettant en oeuvre un brassage identité $\pi_{=12}$ et un module mettant en oeuvre un brassage $\pi_{B12}$.
On peut remarquer que ce codeur comporte trois codeurs mettant en oeuvre des codes appelés précédemment code Cortex-Golay $C_1$(24, 12, 8) « simplifié », identifiés sur la figure 7a respectivement par les modules de codage de base (B0, B1, B2), (C0, C1, C2), (D0, D1, D2) pour le codeur Cortex-Golay $C_1$(24, 12, 8) du haut, et (B3, B4, B5), (C3, C4, C5), (D3, D4, D5) pour le codeur Cortex-Golay $C_1$(24, 12, 8) du milieu et (B6, B7, B8), (C6, C7, C8), (D6, D7, D8) pour le codeur Cortex-Golay $C_1$(24, 12, 8) du bas, et les permutations $\pi0$ (de type 4-cyclique et de paramètre $\Delta$=1).
Les sorties du codeur Cortex-Golay $C_1$(24, 12, 8) du haut entrent sur le premier module de brassage $\pi_{=12}$ du premier sous-étage de brassage postérieur $\pi11$ mettant en oeuvre un brassage identité (ou une absence de brassage).
Les sorties du codeur Cortex-Golay $C_1$(24, 12, 8) du milieu entrent sur le deuxième module de brassage $\pi_{B12}$ du premier sous-étage de brassage postérieur $\pi11$ mettant en oeuvre le brassage suivant:

$$\pi_{Bk}(i) = \left\lfloor \frac{i}{p} \right\rfloor + 4 * (i \bmod p) \quad \forall i = 0, 1, ..., (k\text{-}1), \text{ avec } p = \left\lfloor \frac{k}{4} \right\rfloor.$$

Par exemple, pour *k* égal à 12, comme illustré en figure 7a, *p* est égal à 3 et on obtient les positions suivantes en sorties du deuxième module de brassage : $\pi_{B12}$ = {0, 4, 8, 1, 5, 9, 2, 6, 10, 3, 7, 11},

Les sorties du codeur Cortex-Golay $C_1$(24, 12, 8) du bas entrent quant à elles sur le troisième module de brassage $\pi$=12 du premier sous-étage de brassage postérieur $\pi11$ mettant en oeuvre un brassage identité.

L'utilisation de ces modules de brassage distincts, dans un même sous-étage de brassage postérieur $\pi11$ de l'étage de brassage postérieur $\pi1$, est fondamentale pour obtenir une grande diversité de codes résultants.

Le deuxième sous-étage de brassage $\pi_{9,36}$ de l'étage de brassage postérieur $\pi1$ met en oeuvre une permutation de type 4-cyclique de paramètre $\Delta$ égal à 9 et de longueur *k* égale à 36.

L'étage de brassage antérieur $\pi$-1 met également en oeuvre deux sous-étages de brassage antérieur différents $\pi_{9,36}$ et $\pi$-11.

Le premier sous-étage de brassage antérieur $\pi_{9,36}$ met en oeuvre une permutation de type 4-cyclique de paramètre $\Delta$ égal à 9 et de longueur *k* égale à 36, identique au sous-étage de brassage postérieur noté $\pi_{9,36}$.

Le deuxième sous-étage de brassage antérieur $\pi$-11 met quant à lui en oeuvre deux types de permutation différents dans ces trois modules de brassage : la permutation $\pi_{B12}^{-1}$, mettant en oeuvre un brassage inverse au brassage défini pour $\pi12$, et la permutation identité $\pi$=12.

On peut ainsi exprimer les différentes permutations mises en oeuvre dans la construction de ce codeur, noté codeur Cortex $C_3$(72, 36) de la manière suivante :

$$\Pi(C_3) = \left\{ \pi_{-1}, \pi_0, \pi_0, \pi_1 \right\},$$

avec :

$$\pi_{-1} = \pi_{9,36} \circ (\pi_{B12}^{-1} * \pi_{=12} * \pi_{B12}^{-1})$$

$$\text{et } \pi_1 = (\pi_{=12} * \pi_{B12} * \pi_{=12}) \circ \pi_{9,36}$$

ou, avec une notation simplifiée : $C_3 = (C_1 * C_1 * C_1, \Delta_1 = 9)$,

avec * l'opérateur superposant des permutations et l'opérateur concaténant des permutations.

Les permutations $\pi0$ sont de type 4-cyclique et de paramètre $\Delta$=1.

La matrice P de transfert de ce code Cortex $C_3$(72, 36) est illustrée en figure 7b.

Le polynôme énumérateur des poids des lignes de cette matrice P est égal à : $W_p(X) = 12X^{15} + 22^{19} + 2X^{33}$, avec un poids minimal $w_{min}$ = 15 et une distance minimale $d_{min} \leq 16$.

*5.8 Description d'un sixième mode de réalisation*

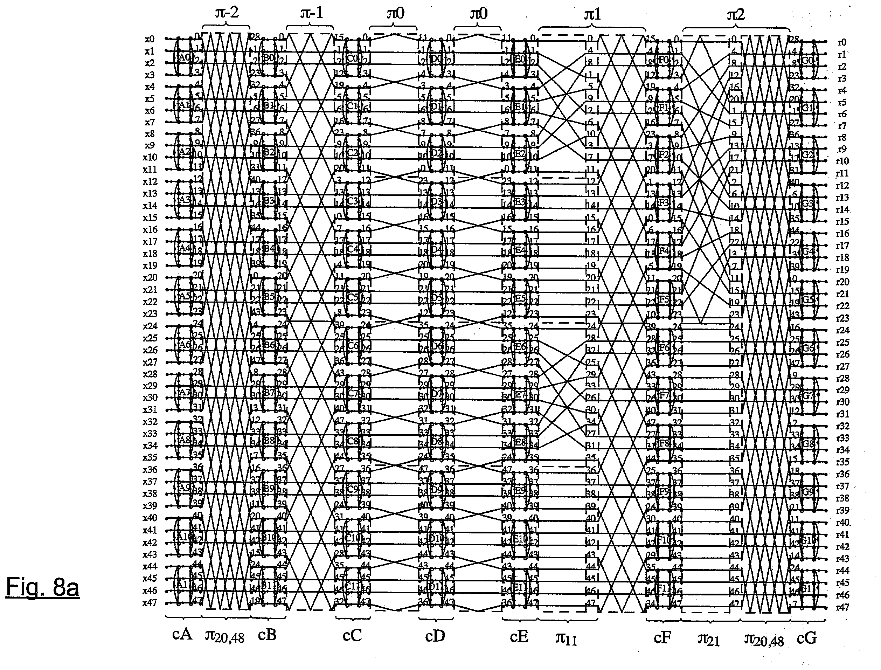

On présente maintenant, en relation avec les figures 8a et 8b, un sixième mode de réalisation du dispositif de codage selon l'invention.

La figure 8a illustre un codeur selon l'invention, prenant en entrée les données (x0, x1, x2 ... x47) et délivrant en sortie les données de redondance (r0, r1, r2 ... r47).

Le codeur ainsi réalisé comprend sept étages de codage cA, cB, cC, cD, cE, cF et cG, comprenant chacun douze modules de codage de base (A0...A11), (B0...B11), (C0...C11), (D0...D11), (E0...E11), (F0...F11), (G0...G11) mettant chacun en oeuvre un code de Hamming compact C4, deux étages de permutation $\pi0$, deux étages de brassage antérieur $\pi$-2 et $\pi$-1 et deux étages de brassage postérieur $\pi1$ et $\pi2$.

On peut noter que ce codeur, appelé codeur Cortex $C_4$(96, 48, $d_{min} \leq$ 20), comporte deux codeurs $C_2$(48, 24) (illustré en figure 6a).

Le premier étage de brassage antérieur $\pi$-2 met en oeuvre une permutation $\pi_{20,48}$ de type 4-cyclique de paramètre $\Delta$ égal à 20 et de longueur *k* égale à 48.

Le deuxième étage de brassage antérieur $\pi$-1 met en oeuvre une superposition de deux permutations $\pi_{9,24}$ telles que définies en relation avec la figure 6a.

Le premier étage de brassage postérieur $\pi1$ comprend deux sous-étages de brassage postérieur :

-    le premier sous-étage de brassage postérieur $\pi11$ comprend quatre modules de brassage, dont deux modules mettant en oeuvre un brassage identité $\pi$=12 et deux module mettant en oeuvre un brassage $\pi_{B12}$ tel que décrit en relation avec la figure 6a ;
- le deuxième sous-étage de brassage postérieur met en oeuvre un brassage

$$(\pi_{9,24})^{2*} = (\pi_{9,24}) * (\pi_{9,24}).$$

Le deuxième étage de brassage postérieur $\pi2$ comporte également deux sous-étages de brassage postérieur $\pi21$ et $\pi_{20,48}$ :

- le sous-étage de brassage $\pi21$ comprend deux modules de brassage mettant en oeuvre des permutations distinctes, dont un module mettant en oeuvre une permutation $\pi_{B24}$ et un module mettant en oeuvre une permutation identité $\pi=24$.

On peut ainsi exprimer les différentes permutations mises en oeuvre dans la construction de ce codeur Cortex $C_4(96, 48, d_{min} \leq 20)$ de la manière suivante :

$$\pi_{-2} = \pi_{20,48}$$

$$\pi_{-1} = (\pi_{9,24})^{2*}$$

$$\pi_1 = (\pi_{B12} * \pi_{=12})^{2*} \circ (\pi_{9,24})^{2*}$$

$$\pi_2 = (\pi_{B24} * \pi_{=24}) \circ \pi_{20,48}.$$

On note de façon simplifiée : $C_4 = (C_2 * C_2, \Delta_2 = 20)$.
Les permutations $\pi0$ sont de type 4-cyclique et de paramètre $\Delta=1$.
La matrice P de transfert de ce code Cortex $C_4(96, 48, d_{min} \leq 20)$ est illustrée en figure 8b.
Le polynôme énumérateur des poids des lignes de cette matrice P est égal à : $W_p(X) = 7X^{19} + 17X^{23} + 19X^{27} + 4X^{31} + X^{35}$, avec un poids minimal $w_{min} = 19$ et une distance minimale $d_{min} \leq 20$.

*5.9 Description d'autres modes de réalisation*

Un septième mode de réalisation de l'invention permet d'obtenir un codeur appelé Cortex $C_8(192, 96, d_{min} \leq 36)$, composé notamment de deux codeurs Cortex $C_4(96, 48)$ tels que décrit ci-dessus.
Ce codeur Cortex $C_8(192, 96, d_{min} \leq 36)$ peut s'écrire de façon simplifiée:

$$C_8 = (C_4 * C_4, \Delta_3 = 40).$$

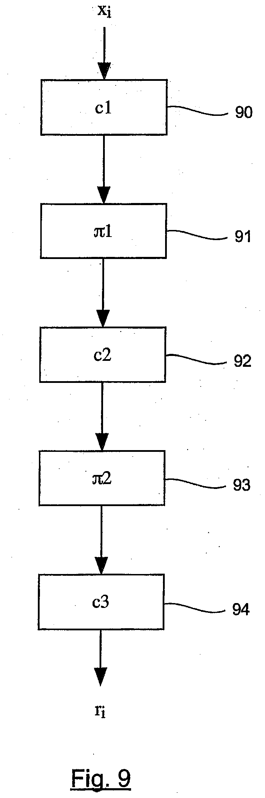

Le polynôme énumérateur des poids des lignes de cette matrice P est égal à : $W_p(X) = X^{35} + 6X^{39} + 22X^{43} + 27X^{47} + 29X^{51} + 10X^{55} + X^{59}$, avec un poids minimal $w_{min} = 35$ et une distance minimale $d_{min} \leq 36$.
L'annexe 1, faisant partie intégrante de la présente description, présente un tableau d'exemples de paramètres de codeurs obtenus selon différents modes de réalisation de l'invention.
On note ainsi que l'invention permet de construire de nouveaux codes, en utilisant des modules de codage de base et des permutations spécifiques.
Les modes de réalisation précédemment détaillés en relation avec les figures 1 à 8, peuvent également être décrits sous la forme de procédés de codage correcteur d'erreurs. Les codes construits selon la technique proposée peuvent en effet être implémentés de diverses manières, notamment sous forme câblée ou sous forme logicielle.
Ainsi, la figure 9 présente les principales étapes d'un procédé de codage correcteur d'erreurs selon un mode de réalisation de l'invention, prenant en entrées des données source $x_i$ et délivrant des données de redondance $r_i$,

La première étape 90 de codage c1 reçoit les données source $x_i$ et met un oeuvre un ensemble de trois modules de codage de base, chaque module de codage mettant en oeuvre un code de base. Le code de base peut être par exemple un code de Hamming compact ou un demi-code de Hamming tel que décrit prédécemment.

Les données traitées issues de cette première étape de codage 90 sont ensuite permutées, lors d'une étape 91 de permutation π1. La permutation π1 est une permutation de type c-cyclique, telle que définie précédemment.

Les données permutées sont alors traitées lors d'une étape 92 de codage intermédiaire c2, mettant également en oeuvre un ensemble de trois modules de codage de base, chaque module de codage mettant en oeuvre un code de base..

Les données traitées issues de cette deuxième étape de codage 92 sont ensuite à nouveau permutées, lors d'une étape 93 de permutation π1 de type c-cyclique.

Enfin, les données permutées sont traitées lors d'une dernière étape 94 de codage c3, mettant également en oeuvre un ensemble de trois modules de codage de base, chaque module de codage mettant en oeuvre un code de base. Les données issues de cette dernière étape 94 de codage sont les données de redondance $r_i$.

Un tel procédé de codage correcteur d'erreurs peut notamment permettre de construire un code tel que décrit précédemment, en relation avec les figures 3a et 3b.

Bien entendu, d'autres étapes de codage et de permutation peuvent également être mises en oeuvre pour construire les codes décrits précédemment, et notamment ceux illustrés aux figures 4a, 5a, 6a, 7a et 8a.

Afin de faire varier le rendement du code obtenu, il est également possible de « forcer » (c'est-à-dire affecter une valeur constante) des symboles à la valeur zéro, en entrée sur les symboles d'information et en sortie sur les symboles de redondance.

**Annexe 1**

| Indices $(m, a)$ | Code construit $C_{2^m+a}$ $(n, k, d_{min} \leq d^*_{min})$ | Codes de base de la construction | Paramètre $\Delta_m$ | Nombre d'étages $2m+3$ |
|---|---|---|---|---|
| (0, 0) | $C_1$ (24, 12, $d_{min} \leq 8$) | $C_0*C_0*C_0$ | $\Delta_0 = 1$ | 3 |
| (1, 0) | $C_2$ (48, 24, $d_{min} \leq 12$) | $C_1*C_1$ | $\Delta_1 = 9$ | 5 |
| (1, 1) | $C_3$ (72, 36, $d_{min} \leq 16$) | $C_1*C_1*C_1$ | $\Delta_1 = 9$ | 5 |
| (2, 0) | $C_4$ (96, 48, $d_{min} \leq 20$) | $C_2*C_2$ | $\Delta_2 = 20$ | 7 |
| (2, 1) | $C_5$ (120, 60, $d_{min} \leq 24$) | $C_3*C_2$ | $\Delta_2 = 20$ | 7 |
| (2, 2) | $C_6$ (144, 72, $d_{min} \leq 28$) | $C_3*C_3$ | $\Delta_2 = 20$ | 7 |
| (2, 3) | $C_7$ (168, 84, $d_{min} \leq 32$) | $C_4*C_3$ | $\Delta_2 = 20$ | 7 |
| (3, 0) | $C_8$ (192, 96, $d_{min} \leq 36$) | $C_4*C_4$ | $\Delta_3 = 40$ | 9 |
| (3, 1) | $C_9$ (216, 108, $d_{min} \leq 24$) | $C_5*C_4$ | $\Delta_3 = 40$ | 9 |
| (3, 2) | $C_{10}$ (240, 120, $d_{min} \leq 28$) | $C_5*C_5$ | $\Delta_3 = 40$ | 9 |
| (3, 3) | $C_{11}$ (264, 132, $d_{min} \leq 32$) | $C_6*C_5$ | $\Delta_3 = 40$ | 9 |
| (3, 4) | $C_{12}$ (288, 144, $d_{min} \leq 32$) | $C_6*C_6$ | $\Delta_3 = 40$ | 9 |
| (3, 5) | $C_{13}$ (312, 156, $d_{min} \leq 32$) | $C_7*C_6$ | $\Delta_3 = 40$ | 9 |
| (3, 6) | $C_{14}$ (336, 168, $d_{min} \leq 32$) | $C_7*C_7$ | $\Delta_3 = 40$ | 9 |
| (3, 7) | $C_{15}$ (360, 180, $d_{min} \leq 32$) | $C_8*C_7$ | $\Delta_3 = 40$ | 9 |
| (4, 0) | $C_{16}$ (384, 192, $d_{min} \leq 68$) | $C_8*C_8$ | $\Delta_4 = 80$ | 11 |
| (4, 1) | $C_{17}$ (408, 204, $d_{min} \leq 72$) | $C_9*C_8$ | $\Delta_4 = 80$ | 11 |
| (4, 2) | $C_{18}$ (432, 216, $d_{min} \leq 76$) | $C_9*C_9$ | $\Delta_4 = 80$ | 11 |
| (4, 3) | $C_{19}$ (456, 228, $d_{min} \leq 80$) | $C_{10}*C_9$ | $\Delta_4 = 80$ | 11 |
| (4, 4) | $C_{20}$ (480, 240, $d_{min} \leq 84$) | $C_{10}*C_{10}$ | $\Delta_4 = 80$ | 11 |
| (4, 5) | $C_{21}$ (504, 252, $d_{min} \leq 88$) | $C_{11}*C_{10}$ | $\Delta_4 = 80$ | 11 |

(suite)

| Indices $(m, a)$ | Code construit $C_{2^m+a}$ $(n, k, d_{min} \le d^*_{min})$ | Codes de base de la construction | Paramètre $\Delta_m$ | Nombre d'étages $2m+3$ |
|---|---|---|---|---|
| (4, 6) | $C_{22}$ (458, 228, $d_{min} \le 92$) | $C_{11}{}^*C_{11}$ | $\Delta_4 = 80$ | 11 |
| (4, 7) | $C_{23}$ (458, 228, $d_{min} \le 96$) | $C_{12}{}^*C_{11}$ | $\Delta_4 = 80$ | 11 |
| (4, 8) | $C_{24}$ (458, 228, $d_{min} \le 100$) | $C_{12}{}^*C_{12}$ | $\Delta_4 = 80$ | 11 |
| (4, 9) | $C_{25}$ (458, 228, $d_{min} \le 104$) | $C_{13}{}^*C_{12}$ | $\Delta_4 = 80$ | 11 |
| (4, 10) | $C_{26}$ (624, 312, $d_{min} \le 108$) | $C_{13}{}^*C_{13}$ | $\Delta_4 = 80$ | 11 |
| (4, 11) | $C_{27}$ (648, 324, $d_{min} \le 112$) | $C_{14}{}^*C_{13}$ | $\Delta_4 = 80$ | 11 |
| (4, 12) | $C_{28}$ (672, 336, $d_{min} \le 116$) | $C_{14}{}^*C_{14}$ | $\Delta_4 = 80$ | 11 |
| (4, 13) | $C_{29}$ (696, 348, $d_{min} \le 120$) | $C_{15}{}^*C_{14}$ | $\Delta_4 = 80$ | 11 |
| (4,14) | $C_{30}$ (720, 360, $d_{min} \le 124$) | $C_{15}{}^*C_{15}$ | $\Delta_4 = 80$ | 11 |
| (4, 15) | $C_{31}$ (744, 372, $d_{min} \le 128$) | $C_{16}{}^*C_{15}$ | $\Delta_4 = 80$ | 11 |
| (5, 0) | $C_{32}$ (768, 384, $d_{min} \le 132$) | $C_{16}{}^*C_{16}$ | $\Delta_5 = 160$ | 13 |

**Revendications**

1. Dispositif de codage correcteur d'erreurs, du type associant des données de redondance (r0 àr11) à des données source (x0 à x11),
   ledit dispositif comprenant:

   - au moins trois étages de codage mettant en oeuvre chacun au moins un ensemble de trois modules de codage de base (A0, A1, A2) (B0, B1, B2) (C0, C1, C2), dont un premier étage de codage (cA), un dernier étage de codage (cC) et au moins un étage de codage intermédiaire (cB);
   chaque module de codage mettant en oeuvre un code de base,
   chaque étage de codage recevant des données à traiter réparties entre les différents modules de codage de base et délivrant des données traitées issues desdits modules de codage de base,
   ledit premier étage de codage recevant lesdites données source et ledit dernier étage de codage délivrant lesdites données de redondance; et
   - au moins deux étages de permutation ($\pi$0), lesdits étages de permutation étant insérés entre deux étages de codage successifs, dits étage de codage précédent et étage de codage suivant, et répartissant les données traitées issues de chaque module de codage de base de l'étage de codage précédent entre au moins deux modules de codage de base de l'étage de codage suivant;

   **caractérisé en ce que** chaque module de codage de base comprend $c$ entrées et $c$ sorties, avec c un entier, et **en ce que** chaque étage de permutation met en oeuvre une permutation de type $c$-cyclique s'écrivant sous la forme:

$$\forall i = 0, 1, \ldots, (k-1) \begin{cases} \pi_{\Delta,k}(i) = \Delta_0 + i(\bmod\,k)\,si\,i \equiv 0\,(\bmod\,c) \\ \pi_{\Delta,k}(i) = \Delta_1 + i(\bmod\,k)\,si\,i \equiv 1\,(\bmod\,c) \\ \quad\vdots \qquad\qquad \vdots \\ \pi_{\Delta,k}(i) = \Delta_{c-1} + i(\bmod\,k)\,si\,i \equiv (c-1)\,(\bmod\,c) \end{cases}$$

k étant le nombre de données sources avec pour conditions que $\Delta = \{\Delta_0, \Delta_1, \ldots, \Delta_{c-1}\}$ est un ensemble de paramètres entiers tels que:

- les paramètres $(\Delta_0,\Delta_1,\cdots,\Delta_{c-1})$ doivent prendre au moins trois valeurs différentes, ou
- si les paramètres $(\Delta_0,\Delta_1,\cdots,\Delta_{c-1})$ ne prennent que deux valeurs différentes alors chacune des deux valeurs est au moins présente deux fois dans l'ensemble $\Delta$;

et **en ce que** les modules de codage de base sont choisis de telle manière que, combinés aux permutations de type c-cyclique, le code résultant est auto-dual, et **en ce que** les codes mis en oeuvre par les modules de codage de base appartiennent au groupe comprenant les codes de Hamming, les demi-codes de Hamming ou les codes identités.

2. Dispositif de codage correcteur d'erreurs selon la revendication 1, **caractérisé en ce que** lesdits codes de base appartiennent au groupe comprenant:

- un code de Hamming de matrice de transfert $P$;
- un demi-code de Hamming de matrice de transfert $P^+$ ou $P^-$, résultant d'un découpage en deux d'un code de Hamming de matrice de transfert $P$, tel que

$$P = P^+ \times P^- = P^- \times P^+$$

un demi-code à gauche tel que:

- pour les indices pairs (2i) avec $0 \leq 2i \leq (c-1)$:

$$r_{2i} = \sum_{j=-m}^{j=+m} x_{2i+j}, \text{ où } m = \left\lfloor \frac{\text{degré}}{2} \right\rfloor$$ l'opérateur $\Sigma$ est l'opérateur somme modulo 2, encore appelé «OU exclusif», et où le degré correspond au nombre d'entrées des «OU exclusif»;

- pour les indices impairs (2i+1) avec $1 \leq 2i+1 \leq (c-1)$:

$$r_{2i+1} = x_{2i+1},$$

avec $r_i$ données de redondance et $x_i$ données source;
- un demi-code à droite dual dudit demi-code à gauche tel que:

- pour les indices pairs (2i) avec $0 \leq 2i \leq (c-1)$:

$$r_{2i} = x_{2i},$$

- pour les indices impairs (2i+1) avec $1 \leq 2i+1 \leq (c-1)$: $r_{2i+1} = \sum_{j=-m}^{j=+m} x_{2i+1+j}$, où $m = \left\lfloor \frac{\text{degré}}{2} \right\rfloor$ l'opérateur $\Sigma$ est l'opérateur somme modulo 2, encore appelé «OU exclusif», et où le degré correspond au nombre d'entrées des «OU exclusif»;
avec $r_i$ données de redondance et $x_i$ données source;

- un code identité.

3. Dispositif de codage correcteur d'erreurs selon la revendication 1, **caractérisé en ce qu'**il comprend au moins un étage de brassage postérieur, inséré entre deux étages de codage successifs, un étage de brassage postérieur comprenant deux sous-étages de brassage successifs, dits premier et deuxième sous-étages de brassage postérieur, mettant en oeuvre des brassages de type différent et **en ce que** ledit premier sous-étage de brassage postérieur comprend au moins deux modules de brassage distincts,
chaque module de brassage recevant des données traitées issues d'au moins un ensemble de trois modules de codage d'un même étage de codage intermédiaire et délivrant des données brassées, prises en entrée dudit deuxiéme sous-étage de brassage postérieur, chaque module de brassage mettant en oeuvre des brassages de type différent,

et **en ce que** le ledit dispositif comprend au moins un étage de brassage antérieur, inséré entre deux étages de codage successifs,

un étage de brassage antérieur comprenant au moins un sous-étage de brassage antérieur mettant en oeuvre un brassage identique à un deuxiéme sous-étage de brassage postérieur d'un desdits étages de brassage postérieur.

4. Dispositif de codage correcteur d'erreurs selon la revendication 3, **caractérisé en ce que** ledit étage de brassage antérieur comprend au moins deux sous-étages de brassage successifs, dits premier et deuxiéme sous-étages de brassage antérieur, mettant en oeuvre des brassages de type différent, et **en ce que** ledit deuxiéme sous-étage de brassage antérieur comprend au moins deux modules de brassage distincts,

chaque module de brassage recevant des données brassées dudit premier sous-étage de brassage antérieur, et fournissant des données re-brassées à au moins un ensemble de trois modules de codage d'un même étage de codage intermédiaire,

chaque module de brassage distinct mettant en oeuvre des brassages de type différent.

5. Dispositif de codage correcteur d'erreurs selon la revendication 3, **caractérisé en ce que** lesdits modules de brassage ou sous-étages de brassage mettent en oeuvre un brassage appartenant au groupe comprenant:

- un brassage identité tel que:

$$\forall i = 0, 1, \ldots, (k\text{-}1) \quad \pi_k(i) = i \; ;$$

- un brassage tel que:

$$\forall i = 0, 1, \ldots, (k\text{-}1) \begin{cases} \pi_{\Delta,k}(i) = \Delta_0 + i(\operatorname{mod} k)\, si\, i = 0\,(\operatorname{mod} c) \\ \pi_{\Delta,k}(i) = \Delta_1 + i(\operatorname{mod} k)\, si\, i = 1\,(\operatorname{mod} c) \\ \qquad \cdot \\ \qquad \cdot \\ \qquad \cdot \\ \pi_{\Delta,k}(i) = \Delta_{c-1} + i(\operatorname{mod} k)\, si\, i = (c-1)\,(\operatorname{mod} c) \end{cases} ;$$

avec pour conditions que $\Delta = \{\Delta_0,\Delta_1,\ldots,\Delta_{c\text{-}1}\}$ est un ensemble de paramètres entiers tels que:

- les paramètres $(\Delta_0,\Delta_1,\cdots,\Delta_{c\text{-}1})$ doivent prendre au moins trois valeurs différentes, ou
- si les paramètres $(\Delta_0,\Delta_1,\cdots,\Delta_{c\text{-}1})$ prennent que deux valeurs différentes alors chacune des deux valeurs est au moins présente deux fois dans l'ensemble $\Delta$,

- un brassage tel que:

$$\pi_{Bk}(i) = \left\lfloor \frac{i}{p} \right\rfloor + c * (i \bmod p) \quad \forall i = 0, 1, \ldots, (k\text{-}1), \text{avec } p = \left\lfloor \frac{k}{c} \right\rfloor ,$$

avec $k$ la longueur de permutation.

6. Dispositif de codage correcteur d'erreurs selon la revendication 1, **caractérisé en ce que** tous lesdits modules de codage de base mettent en oeuvre un code de base identique.

7. Dispositif de codage correcteur d'erreurs selon la revendication 6, **caractérisé en ce que** ledit code de base identique est un code de Hamming de longueur $n$ égale à huit, comprenant $k$ égal à quatre symboles d'information utiles et

de distance minimale $d_{min}$ égale à quatre.

8. Dispositif de codage correcteur d'erreurs selon la revendication 1, **caractérisé en ce que** lesdits étages de permutation répartissent deux données traitées issues d'un module de codage de base d'un étage de codage précédent vers au moins deux modules de codage de base d'un étage de codage suivant.

9. Dispositif de codage correcteur d'erreurs selon la revendication 1, **caractérisé en ce qu'**il comprend un module de forçage à zéro, mettant à la valeur nulle au moins une desdites données source et/ou au moins une desdites données de redondance.

10. Procédé de codage correcteur d'erreurs, du type associant des données de redondance à des données source, ledit procédé mettant en oeuvre:

   - au moins trois étapes de codage dont une première étape de codage, une dernière étape de codage et au moins une étape de codage intermédiaire, mettant chacune en oeuvre au moins un ensemble de trois modules de codage de base, chaque module de codage mettant un oeuvre un code de base, chaque étape de codage recevant des données à traiter réparties entre les différents modules de codage de base et délivrant des données traitées issues desdits modules de codage de base, ladite première étape de codage recevant lesdites données source et ladite dernière étape de codage délivrant lesdites données de redondance; et
   - au moins deux étapes de permutation, lesdites étapes de permutation étant mises en oeuvre entre deux étapes de codage successives, dites étape de codage précédent et étape de codage suivant, et répartissant les données traitées issues de chaque module de codage de base mis en oeuvre dans l'étape de codage précédent entre au moins deux modules de codage de base mis en oeuvre dans l'étape de codage suivant; **caractérisé en ce que** chaque module de codage de base comprend c entrées et c sorties, avec c un entier, et **en ce que** chaque étape de permutation met en oeuvre une permutation de type c-cyclique s'écrivant sous la forme:

$$\forall i = 0, 1, \ldots, (k\text{-}1) \begin{cases} \pi_{\Delta,k}(i) = \Delta_0 + i(\text{mod } k) \; si \; i \equiv 0 \, (\text{mod } c) \\ \pi_{\Delta,k}(i) = \Delta_1 + i(\text{mod } k) \; si \; i \equiv 1 \, (\text{mod } c) \\ \vdots \qquad\qquad \vdots \\ \vdots \qquad\qquad \vdots \\ \pi_{\Delta,k}(i) = \Delta_{c-1} + i(\text{mod } k) \; si \; i \equiv (c-1) \, (\text{mod } c) \end{cases},$$

k étant le nombre de données sources avec pour conditions que $\Delta = \{\Delta_0, \Delta_1, \ldots, \Delta_{c-1}\}$ est un ensemble de paramètres entiers tels que:

   - les paramètres $(\Delta_0, \Delta_1, \cdots, \Delta_{c-1})$ doivent prendre au moins trois valeurs différentes, ou
   - si les paramètres $(\Delta_0, \Delta_1, \cdots, \Delta_{c-1})$ ne prennent que deux valeurs différentes alors chacune des deux valeurs est au moins présente deux fois dans l'ensemble $\Delta$;
   - les modules de codage de base sont choisis de telle manière que, combinés aux permutations de type c-cyclique, le code résultant est auto-dual;
   - les codes mis en oeuvre par les modules de codage de base appartiennent au groupe comprenant les codes de Hamming, les demi-codes de Hamming ou les codes identités.

11. Programme d'ordinateur comportant des instructions pour la mise en oeuvre du procédé de codage correcteur d'erreurs selon la revendication 10 lorsque ledit programme est exécuté par un processeur.

**Patentansprüche**

1. Fehlerkorrigierendes Kodierungsinstrument, das Redundanz-Daten (r0 bis r11) mit Quelldaten (x0 bis x11) verbindet, das Instrument umfasst:

- mindestens drei Kodierungsstufen, von denen jede mindestens einen Satz von drei Basiskodierungsmodulen umsetzt (A0, A1, A2) (B0, B1, B2) (C0, C1, C2), darunter eine erste Kodierungsstufe (cA), eine letzte Kodierungsstufe (cC) und zumindest eine mittlere Kodierungsstufe (cB); jedes Kodierungsmodul setzt einen Basiscode um, jede Kodierungsstufe empfängt Daten die aufgeteilt auf die verschiedenen Basiskodierungsmodule behandelt werden sollen und Daten liefern sollen, die aus diesen Basiskodierungsmodulen stammen, die erste Kodierungsstufe soll die Quelldaten empfangen und die letzte Kodierungsstufe soll die Redundanz-Daten liefern; und

- zumindest zwei Permutationsstufen ($\pi$0), die beiden Permutationsstufen sollen zwischen zwei aufeinander folgenden Kodierungsstufen (einer Vor-Kodierungsstufe und einer Nach-Kodierungsstufe) eingefügt werden und die Daten, die aus jedem Basiskodierungsmodul der Vor-Kodierungsstufe stammen, aufteilen auf zumindest zwei Basiskodierungsmodule der Nach-Kodierungsstufe;

**dadurch gekennzeichnet, dass** jedes Basiskodierungsmodul c-Inputs und c-Outputs enthält wobei c ganzzahlig ist, und dadurch, dass jede Permutationsstufe eine Permutation des Typs c zyklisch umsetzt, geschrieben in folgender Form:

$$\forall i = 0, 1, \ldots, (k-1) \begin{cases} \pi_{\Delta,k}(i) = \Delta_0 + i(\bmod\, k)\ si\ i \equiv 0\,(\bmod\, c) \\ \pi_{\Delta,k}(i) = \Delta_1 + i(\bmod\, k)\ si\ i \equiv 1\,(\bmod\, c) \\ \cdot \qquad\qquad \cdot \\ \cdot \qquad\qquad \cdot \\ \cdot \qquad\qquad \cdot \\ \pi_{\Delta,k}(i) = \Delta_{c-1} + i(\bmod\, k)\ si\ i \equiv (c-1)(\bmod\, c) \end{cases}$$

k ist die Anzahl der Quelldaten
unter der Bedingung, dass $\Delta = \{\Delta_0, \Delta_1, \ldots, \Delta_{c-1}\}$ ein Satz ganzer Parameter ist, sowie:

- die Parameter ($\Delta_0, \Delta_1, \cdots, \Delta_{c-1}$) müssen zumindest drei verschiedene Werte annehmen oder
- wenn die Parameter ($\Delta_0, \Delta_1, \cdots, \Delta_{c-1}$) nur zwei verschiedene Werte annehmen, dann ist jeder der beiden Werte mindestens zwei Mal im Satz $\Delta$ vertreten;

und dadurch, dass die Basiskodierungsmodule so ausgewählt werden, dass sie kombiniert mit den Permutationen des Typs c zyklisch, einen Code ergeben, der auto-dual ist, und dadurch, dass die Codes, umgesetzt durch die Basiskodierungsmodule, Teil der Gruppe sind, die die Hamming-Codes, die Halb-Codes von Hamming oder die Identitätscodes enthalten.

2. Fehlerkorrigierendes Kodierungsinstrument gemäß Anspruch 1, **dadurch gekennzeichnet, dass** die Basis-Codes Teil der Gruppe sind, die umfasst:

- einen *P*-Transfer-Matrix-Code von Hamming
- einen *P*$^+$- oder *P*$^-$-Transfer-Matrix-Halb-Code von Hamming, resultierend aus der Halbierung eines *P*-Transfer-Matrix-Codes von Hamming, so wie $P = P^+ \times P^- = P^- \times P^+$ ein Halb-Code links, sowie
- für die geraden Zahlen (2i) mit $0 \leq 2i < (c-1)$:

$$r_{2i} = \sum_{j=-m}^{j=+m} x_{2i+j} \quad \text{oder} \quad m = \left\lfloor \frac{\text{Grad}}{2} \right\rfloor \quad \text{der Operator} \Sigma \text{ ist der Operator der Modulo-2-Summe, auch genannt}$$

"exklusives Oder", und, wo der Grad der Anzahl der Inputs entspricht, der "exklusiven Oders";

- für die ungeraden Zahlen (2i+1) mit $1 \leq 2i+1 \leq (c-1)$:

$$r_{2i+1} = x_{2i+1},$$

mit $r_i$ Redundanz-Daten und $X_i$ Quelldaten;
- ein Halb-Code rechts dual zum genannten Halb-Code links, wie:

- für die geraden Zahlen (2i) mit $0 \leq 2i \leq (c-1)$:

$$r_{2i} = x_{2i},$$

- für die ungeraden Zahlen (2i+1) mit $1 \leq 2i+1 \leq (c-1)$: $r_{2i+1} = \sum_{j=-m}^{j=+m} x_{2i+1+j}$ oder $m = \left\lfloor \dfrac{\text{Grad}}{2} \right\rfloor$ der Operator $\Sigma$

ist der Operator der Modulo-2-Summe, auch genannt "exklusives Oder", und, wo der Grad der Anzahl der Inputs entspricht, der "exklusiven Oders";

mit $r_i$ Redundanzdaten und $X_i$ Quelldaten;

- ein Identitätscode.

3. Fehlerkorrigierendes Kodierungsinstrument gemäß Anspruch 1, **dadurch gekennzeichnet, dass** es zumindest eine Nachmischstufe enthält, eingefügt zwischen zwei aufeinander folgenden Kodierungsstufen, wobei eine Nachmischstufe zwei aufeinander folgende Unter-Mischstufen enthält, genannt die erste Unter-Nachmischstufe und die zweite Unter-Nachmischstufe, die Mischungen unterschiedlicher Art umsetzen, und **dadurch gekennzeichnet, dass** die erste Unter-Nachmischstufe zumindest zwei getrennte Misch-Module beinhaltet, jedes Misch-Modul empfängt Daten von zumindest einem Satz von drei Kodierungsmodulen derselben mittleren Kodierungsstufe und liefert gemischte Daten, empfangen als Input von der zweiten Unter-Nachmischstufe, wobei jedes Misch-Modul Mischungen verschiedener Art umsetzt,
und dadurch, dass das genannte Instrument zumindest eine Vormischstufe enthält, die zwischen zwei aufeinander folgende Kodierungsstufen eingefügt ist,
eine Vormischstufe enthält zumindest eine Unter-Vormischstufe, die eine Mischung umsetzt, die ident ist mit einer zweiten Unter-Nachmisch-Stufe, welche wiederum ein Teil ist von einer der Nachmischstufen.

4. Fehlerkorrigierendes Kodierungsinstrument gemäß Anspruch 3, **dadurch gekennzeichnet, dass** die genannte Vormischstufe zumindest zwei aufeinander folgende Untermischstufen enthält, genannt die erste Unter-Vormischstufe und die zweite Unter-Vormischstufe, welche Mischungen unterschiedlicher Art erzeugen, und **dadurch gekennzeichnet, dass** die zweite Unter-Vormischstufe zumindest zwei getrennte Misch-Module enthält,
jedes Mischmodul empfängt gemischte Daten von der ersten Unter-Vormischstufe und liefert neu gemischte Daten an zumindest einen Satz von drei Kodierungsmodulen derselben Mittel-Kodierungsstufe, jedes separate Misch-Modul setzt Mischungen verschiedener Art um.

5. Fehlerkorrigierendes Kodierungsinstrument gemäß Anspruch 3, **dadurch gekennzeichnet, dass** die Misch-Module oder Unter-Mischstufen eine Mischung umsetzen,
zuzuordnen einer Gruppe, die enthält:

- eine Identitätsmischung wie

$$\forall i = 0, 1, \ldots, (k-1) \quad \pi_k(i) = i \ ;$$

- eine Mischung wie

$$\forall i = 0, 1, \ldots, (k-1) \begin{cases} \pi_{\Delta,k}(i) = \Delta_0 + i\,(\text{mod}\,k)\ si\ i \equiv 0\,(\text{mod}\,c) \\ \pi_{\Delta,k}(i) = \Delta_1 + i\,(\text{mod}\,k)\ si\ i \equiv 1\,(\text{mod}\,c) \\ \quad \vdots \\ \pi_{\Delta,k}(i) = \Delta_{c-1} + i\,(\text{mod}\,k)\ si\ i \equiv (c-1)\,(\text{mod}\,c) \end{cases} ;$$

mit der Bedingung, dass $\Delta = \{\Delta_0, \Delta_1, \ldots, \Delta_{c-1}\}$ ein Satz ganzer Parameter ist, sowie:

- die Parameter $(\Delta_0, \Delta_1, \cdots, \Delta_{c-1})$ müssen zumindest drei verschiedene Werte annehmen, oder
- wenn die Parameter $(\Delta_0, \Delta_1, \cdots, \Delta_{c-1})$ nur zwei verschiedene Werte annehmen, dann ist jeder der beiden Werte mindestens zwei Mal im Satz $\Delta$ vertreten,

- eine Mischung wie $\pi_{Bk}(i) = \left\lfloor \dfrac{i}{p} \right\rfloor + c * (i \bmod p) \quad \forall i = 0, 1, \ldots, (k-1) \quad$ mit $p = \left\lfloor \dfrac{k}{c} \right\rfloor$ mit $k$ als Länge der Permutation.

6. Fehlerkorrigierendes Kodierungsinstrument gemäß Anspruch 1, **dadurch gekennzeichnet, dass** die Basiskodierungsmodule einen identen Basiscode umsetzen.

7. Fehlerkorrigierendes Kodierungsinstrument gemäß Anspruch 6, **dadurch gekennzeichnet, dass** der genannte idente Basiscode einem Hamming-Code mit der Länge $n$ ist gleich acht entspricht und $k$ beinhaltet, wobei $k$ gleichgesetzt ist mit vier nützlichen Informationssymbolen, und der Minimaldistanz $d_{min}$ ist gleich vier.

8. Fehlerkorrigierendes Kodierungsinstrument gemäß Anspruch 1, **dadurch gekennzeichnet, dass** die Permutationsstufen zwei bearbeitete Daten aussenden, diese Daten stammen von einem Basiskodierungsmodul von einer Vor-Kodierungsstufe und werden an zumindest zwei Basiskodierungsmodule einer Nach-Kodierungsstufe geschickt.

9. Fehlerkorrigierendes Kodierungsinstrument gemäß Anspruch 1, **dadurch gekennzeichnet, dass** es zumindest ein Null-Forcierungs-Modul enthält und dem Wert Null zumindest eine der Quelldaten und/oder zumindest eine der Redundanz-Daten gibt.

10. Fehlerkorrigierende Kodierungsmethode, die Redundanz-Daten mit Quelldaten verbindet, diese genannte Methode setzt um:

- zumindest drei Kodierungsschritte, darunter einen ersten Kodierungsschritt, einen letzten Kodierungsschritt und zumindest einen mittleren Kodierungsschritt, von denen jeder umsetzt zumindest einen Satz von drei Basiskodierungsmodulen, jedes Kodierungsmodul setzt um einen Basiscode, jeder Kodierungsschritt empfängt Daten, die zur Bearbeitung auf die verschiedenen Basiskodierungsmodule aufgeteilt werden, und sendet Daten, die aus diesen genannten Basiskodierungsmodulen stammen, der erste Kodierungsschritt empfängt die Quelldaten und der genannte letzte Kodierungsschritt liefert die Redundanz-Daten; und zumindest zwei
- Permutationsschritte, wobei diese Permutationsschritte umgesetzt werden zwischen zwei aufeinander folgenden Kodierungsschritten, dem sogenannten Vor-Kodierungsschritt und dem sogenannten Nach-Kodierungsschritt, und diese verteilen die Daten, die aus jedem Basiskodierungsmodul kommen, umgesetzt im Vor-Kodierungsschritt zwischen zumindest zwei Basiskodierungsmodulen, umgesetzt im Nach-Kodierungsschritt; **dadurch gekennzeichnet, dass** jedes Basiskodierungsmodul c-Inputs und c-Outputs enthält, wobei c ganzzahlig ist, und dadurch, dass jeder Permutationsschritt eine Permutation des Typs "$c$-zyklisch" umsetzt, geschrieben in folgender Form:

$$\forall i = 0, 1, \ldots, (k-1) \begin{cases} \pi_{\Delta,k}(i) = \Delta_0 + i \,(\bmod\, k)\ si\ i \equiv 0\,(\bmod\, c) \\ \pi_{\Delta,k}(i) = \Delta_1 + i \,(\bmod\, k)\ si\ i \equiv 1\,(\bmod\, c) \\ \quad \vdots \qquad\qquad \vdots \\ \quad \vdots \qquad\qquad \vdots \\ \pi_{\Delta,k}(i) = \Delta_{c-1} + i \,(\bmod\, k)\ si\ i \equiv (c-1)\,(\bmod\, c) \end{cases} ,$$

k ist die Anzahl der Quelldaten unter der Bedingung, dass $\Delta = \{\Delta_0, \Delta_1, \ldots, \Delta_{c-1}\}$ ein Satz ganzer Parametern ist, so wie:

- die Parameter $(\Delta_0, \Delta_1, \cdots, \Delta_{c-1})$ müssen zumindest drei verschiedene Werte annehmen oder
- wenn die Parameter $(\Delta_0, \Delta_1, \cdots, \Delta_{c-1})$ nur zwei verschiedene Werte annehmen, dann ist jeder der beiden Werte mindestens zwei Mal im Satz Δ vertreten;

- die Basiskodierungsmodule werden so gewählt, dass sie kombiniert mit den Permutationen vom Typ c-zyklisch, einen Code erzeugen, der auto-dual ist;
- die Codes, umgesetzt durch die Basiskodierungsmodule, sind Teil der Gruppe, die die Codes von Hamming, die Halb-Codes von Hamming oder Identitäts-Codes beinhaltet.

**11.** Computerprogramm, das Instruktionen enthält für den Einsatz der fehlerkorrigierenden Kodierungsmethode gemäß Anspruch 10, wenn dieses Programm von einem Prozessor ausgeführt wird.

**Claims**

**1.** An error correction coding device, of the type associating redundancy data (r0 to r11) with source data (x0 to x11), said device comprising:

- at least three coding stages each implementing at least one set of three basic coding modules (A0, A1, A2) (B0, B1, B2) (C0, C1, C2), including a first coding stage (cA), a last coding stage (cC) and at least one intermediate coding stage (cB);
each coding module implementing a basic code,
each coding stage receiving data to be processed distributed between the different basic coding modules and delivering processed data from said basic coding modules,
said first coding stage receiving said source data and said last coding stage delivering said redundancy data; and
- at least two permutation stages ($\pi 0$), said permutation stages being inserted between two successive coding stages, called a previous coding stage and a next coding stage, and distributing the processed data from each basic coding module of the previous coding stage between at least two basic coding modules of the next coding stage;

**characterised in that** each basic coding module comprises c inputs and c outputs, with c an integer, and **in that** each permutation stage implements a c-cyclic type permutation written as:

$$\forall i = 0, 1, \ldots, (k\text{-}1) \begin{cases} \pi_{\Delta,k}(i) = \Delta_0 + i(\mathrm{mod}\,k)\,si\,i \equiv 0\,(\mathrm{mod}\,c) \\ \pi_{\Delta,k}(i) = \Delta_1 + i(\mathrm{mod}\,k)\,si\,i \equiv 1\,(\mathrm{mod}\,c) \\ \cdot \qquad\qquad \cdot \\ \cdot \qquad\qquad \cdot \\ \cdot \qquad\qquad \cdot \\ \pi_{\Delta,k}(i) = \Delta_{c\text{-}1} + i(\mathrm{mod}\,k)\,si\,i \equiv (c-1)(\mathrm{mod}\,c) \end{cases}$$

k being the number of source data
with the provisos that $\Delta = \{\Delta_0,\Delta_1,...,\Delta_{c\text{-}1}\}$ is a set of integer parameters such that:

- the parameters $(\Delta_0,\Delta_1,...,\Delta_{c\text{-}1})$ have to take at least three different values, or
- if the parameters $(\Delta_0,\Delta_1,...,\Delta_{c\text{-}1})$ only take two different values, then each of the two values is at least present twice in the set $\Delta$;

and **in that** the basic coding modules are chosen such that, combined with the c-cyclic type permutations, the resultant code is self-dual, and **in that** the codes implemented by the basic coding modules belong to the group comprising the Hamming codes, the half-Hamming codes or the identity codes.

**2.** The error correction coding device according to claim 1, **characterized in that** said basic codes belong to the group comprising:

- a Hamming code of a transfer matrix $P$;
- a half-Hamming code of a transfer matrix $P^+$ or $P^-$, resulting from a division into two of a Hamming code of a transfer matrix $P$, such that

$$P = P^+ \ x \ P^- = P^- \ x \ P^+$$

a left half-code such that:

- for the even indices (2i) with $0 \leq 2i \leq (c-1)$:

$$r_{2i} = \sum_{j=-m}^{j=+m} x_{2i+j}, where \ m = \frac{degree}{2}$$

the operator $\Sigma$ is the modulo 2 sum operator, also called "exclusive OR", and where the degree corresponds to the number of inputs of the "exclusive ORs";
- for the odd indices (2i+1) with $1 \leq 2i+1 \leq (c-1)$:

$$r_{2i+1} = x_{2i+1},$$

with $r_i$ redundancy data and $x_i$ source data;

- a right half-code dual of said left half-code such that:

- for the even indices (2i) with $0 \leq 2i \leq (c-1)$:

$$r_{2i} = x_{2i},$$

- for the odd indices (2i+1) with $1 \leq 2i+1 \leq (c-1)$:

$$r_{2i+1} = \sum_{j=-m}^{j=+m} x_{2i+1+j}, where \ m = \frac{degree}{2}$$

the operator $\Sigma$ is the modulo 2 sum operator, also called "exclusive OR", and where the degree corresponds to the number of inputs of the "exclusive ORs";
with $r_i$ redundancy data and $x_i$ source data;

- an identity code.

3. The error correction coding device according to claim 1, **characterised in that** it comprises at least one posterior mixing stage, inserted between two successive coding stages, a posterior mixing stage comprising two successive mixing sub-stages, called first and second posterior mixing sub-stages, implementing mixings of a different type, and **in that** said first posterior mixing sub-stage comprises at least two distinct mixing modules, each mixing module receiving processed data from at least one set of three coding modules of a same intermediate coding stage and delivering mixed data, taken at the input of said second posterior mixing sub-stage, each mixing module implementing mixings of a different type, and **in that** said device comprises at least one anterior mixing stage, inserted between two successive coding stages, an anterior mixing stage comprising at least one anterior mixing sub-stage implementing an identical mixing to a second posterior mixing sub-stage of one of said posterior mixing stages.

4. The error correction coding device according to claim 3, **characterised in that** said anterior mixing stage comprises at least two successive mixing sub-stages, called a first and a second anterior mixing sub-stages, implementing mixings of a different type, and **in that** said second anterior mixing sub-stage comprises at least two distinct mixing modules, each mixing module receiving mixed data from said first anterior mixing sub-stage, and providing re-mixed data to at least one set of three coding modules of a same intermediate coding stage,
each distinct mixing module implementing mixings of a different type.

**5.** The error correction coding device according to claim 3, **characterised in that** said mixing modules or mixing sub-stages implement a mixing belonging to the group comprising:

- an identity mixing such that:

$$\forall i = 0, 1, ..., (k-1) \quad \pi_k(i) = i \; ;$$

- a mixing such that:

$$\forall i = 0, 1, ..., (k-1) \begin{cases} \pi_{\Delta,k}(i) = \Delta_0 + i (\mod k) \, si \, i \equiv 0 (\mod c) \\ \pi_{\Delta,k}(i) = \Delta_1 + i (\mod k) \, si \, i \equiv 1 (\mod c) \\ \cdot \qquad \cdot \\ \cdot \qquad \cdot \\ \cdot \qquad \cdot \\ \pi_{\Delta,k}(i) = \Delta_{c-1} + i (\mod k) \, si \, i \equiv (c-1) (\mod c) \end{cases} \; ;$$

with the provisos that $\Delta = \{\Delta_0, \Delta_1, ..., \Delta_{c-1}\}$ is a set of integer parameters such that:

- the parameters $(\Delta_0, \Delta_1, ..., \Delta_{c-1})$ have to take at least three different values, or
- if the parameters $(\Delta_0, \Delta_1, ..., \Delta_{c-1})$ only take two different values, then each of the two values is at least present twice in the set $\Delta$;

- a mixing such that:

$$\pi_{B,k}(i) = \left\lfloor \frac{i}{p} \right\rfloor + c * (i \mod p) \quad \forall i = 0, 1, ..., (k-1), \text{avec } p = \left\lfloor \frac{k}{c} \right\rfloor,$$

with $k$ the permutation length.

**6.** The error correction coding device according to claim 1, **characterised in that** all said basic coding modules implement an identical basic code.

**7.** The error correction coding device according to claim 6, **characterised in that** said identical basic code is a Hamming code with a length $n$ equal to eight, comprising $k$ equal to four useful information symbols and with a minimum distance $d_{min}$ equal to four.

**8.** The error correction coding device according to claim 1, **characterised in that** said permutation stages distribute two processed data from a basic coding module of a previous coding stage to at least two basic coding modules of a next coding stage.

**9.** The error correction coding device according to claim 1, **characterised in that** it comprises a zero setting module, nullifying at least one of said source data and/or at least one of said redundancy data.

**10.** An error correction coding method, of the type associating redundancy data with source data, said method implementing:

- at least three coding steps including a first coding step, a last coding step and at least one intermediate coding step, each implementing at least one set of three basic coding modules, each coding module implementing a basic code, each coding step receiving data to be processed distributed between the different basic coding modules and delivering processed data from said basic coding modules, said first coding step receiving said source data and said last coding step delivering said redundancy data; and

- at least two permutation steps, said permutation steps being implemented between two successive coding steps, called a previous coding step and a next coding step, and distributing the processed data from each basic coding module implemented in the previous coding step between at least two basic coding modules implemented in the next coding step;

**characterised in that** each basic coding module comprises $c$ inputs and $c$ outputs, with $c$ an integer, and **in that** each permutation step implements a $c$-cyclic type permutation written as:

$$\forall i = 0, 1, ..., (k-1) \begin{cases} \pi_{\Delta,k}(i) = \Delta_0 + i(\mathrm{mod}\,k)\, si\; i \equiv 0\,(\mathrm{mod}\,c) \\ \pi_{\Delta,k}(i) = \Delta_1 + i(\mathrm{mod}\,k)\, si\; i \equiv 1\,(\mathrm{mod}\,c) \\ \quad\quad\quad\vdots \\ \quad\quad\quad\vdots \\ \pi_{\Delta,k}(i) = \Delta_{c-1} + i(\mathrm{mod}\,k)\, si\; i \equiv (c-1)\,(\mathrm{mod}\,c) \end{cases}$$

k being the number of source data

with the provisos that $\Delta = \{\Delta_0, \Delta_1, ..., \Delta_{c-1}\}$ is a set of integer parameters such that:

- the parameters $(\Delta_0, \Delta_1, ..., \Delta_{c-1})$ have to take at least three different values, or
- if the parameters $(\Delta_0, \Delta_1, ..., \Delta_{c-1})$ only take two different values, then each of the two values is at least present twice in the set $\Delta$;
- the basic coding modules are chosen such that, combined with the c-cyclic type permutations, the resultant code is self-dual;
- the codes implemented by the basic coding modules belong to the group comprising the Hamming codes, the half-Hamming codes or the identity codes.

11. A computer program including instructions for implementing the error correction coding method according to claim 10 when said program is executed by a processor.

C4

**Fig. 1a**

**Fig. 1b**

C4+

**Fig. 2a**

C4-

**Fig. 2b**

Fig. 2c

Fig. 2d

Fig. 2e

Fig. 3a

Fig. 3b

Fig. 4a

Fig. 4b

Fig. 5a

Fig. 5b

Fig. 6a

Fig. 6b

Fig. 7a

Fig. 7b

Fig. 8b

Fig. 8a

$x_i$

c1 — 90

$\pi 1$ — 91

c2 — 92

$\pi 2$ — 93

c3 — 94

$r_i$

Fig. 9

**EP 2 384 547 B1**

## RÉFÉRENCES CITÉES DANS LA DESCRIPTION

**Documents brevets cités dans la description**

• EP 1101288 A, J.C. Carlach et C. Vervoux

**Littérature non-brevet citée dans la description**

• A systematic Construction of Self-Dual Codes. **JEAN-CLAUDE CARLACH ; AYOUB OTMANI.** IEEE TRANSACTIONS ON INFORMATION THEO-RY. IEEE, 01 Novembre 2003, vol. 49, 3005-3009